(19) **Europäisches Patentamt European Patent Office Office européen des brevets**

(11) **EP 4 220 197 B1**

(12) **EUROPEAN PATENT SPECIFICATION**

(45) Date of publication and mention of the grant of the patent:
**25.02.2026 Bulletin 2026/09**

(21) Application number: **20963093.8**

(22) Date of filing: **30.11.2020**

(51) International Patent Classification (IPC):
**G01R 19/00** *(2006.01)* **H02M 3/158** *(2006.01)*

(52) Cooperative Patent Classification (CPC):
**G01R 19/2509; H02M 1/0009; H02M 1/32; H02M 3/1582**

(86) International application number:
**PCT/CN2020/132919**

(87) International publication number:
**WO 2022/110205 (02.06.2022 Gazette 2022/22)**

(54) **VOLTAGE CONVERSION CIRCUIT, VOLTAGE CONVERTER AND ELECTRONIC DEVICE**

SPANNUNGSWANDLERSCHALTUNG, SPANNUNGSWANDLER UND ELEKTRONISCHE VORRICHTUNG

CIRCUIT DE CONVERSION DE TENSION, CONVERTISSEUR DE TENSION ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.08.2023 Bulletin 2023/31**

(73) Proprietor: **Huawei Digital Power Technologies Co., Ltd.**
**Shenzhen, Guangdong 518043 (CN)**

(72) Inventors:
• **LI, Wenguang**
  **Shenzhen, Guangdong 518129 (CN)**
• **LV, Zejie**
  **Shenzhen, Guangdong 518129 (CN)**
• **KE, Yulian**
  **Shenzhen, Guangdong 518129 (CN)**

(74) Representative: **Gill Jennings & Every LLP**
**The Broadgate Tower**
**20 Primrose Street**
**London EC2A 2ES (GB)**

(56) References cited:
**CN-A- 103 683 989      CN-A- 107 290 581**
**CN-A- 107 561 343      CN-A- 107 561 343**
**CN-A- 108 631 593      CN-A- 109 067 176**
**CN-A- 110 350 773      JP-A- 2005 237 052**
**US-A1- 2008 117 656**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## TECHNICAL FIELD

This application relates to the field of voltage converter technologies, and in particular, to a voltage conversion circuit, a voltage converter, and an electronic device.

## BACKGROUND

A buck-boost (Buck-Boost) circuit is a common direct current-direct current voltage (current) conversion circuit and is often used in voltage converters in a plurality of types of power systems. For example, voltage converters in power systems such as a power management system of an electric/a hybrid vehicle, a photovoltaic power generation system, and a communications power supply system all need to implement voltage conversion by using a buck-boost circuit.

Usually, the buck-boost circuit mainly includes a plurality of switching transistors and an inductor, and a charging/discharging status of the inductor in the buck-boost circuit may be controlled by changing conduction and opening of the switching transistors, to implement voltage conversion. In some application scenarios of the buck-boost circuit, an inductor current in the buck-boost circuit usually needs to be detected. For example, the voltage converter may monitor an operating status of the buck-boost circuit based on the inductor current in the buck-boost circuit. For another example, the voltage converter may perform overcurrent protection (over current protection, OCP) based on the inductor current in the buck-boost circuit.

In some current detection solutions, a current sensor (a Hall element) connected to the inductor in series may be added to the buck-boost circuit. The current sensor may detect an inductor current flowing through the inductor and output a current detection signal, to indicate a value of the current inductor current. However, costs of the current sensor are relatively high. This does not help save costs. In addition, a detection latency of the current sensor is relatively large, and consequently an application range of the detection result is limited to a specific degree.

CN107561343A relates to a current detection circuit, a current detection method, and a switch circuit of a switch tube circuit that focus on resolving a problem of high power consumption and poor precision of current detection in the prior art.

JP2005237052A provides a current regulator that can work when a DC-DC circuit works in both a boost mode and a buck mode, so as to reduce a quantity of circuit components.

## SUMMARY

This application provides a voltage conversion circuit, a voltage converter, and an electronic device, to detect an inductor current in the voltage conversion circuit, and also help reduce detection costs of the inductor current and further help shorten a detection latency of the inductor current.

The present invention is defined by the subject-matter of the independent claim 1. Additional features of the invention are presented in the dependent claims. According to a first aspect, an embodiment of this application provides a voltage conversion circuit, mainly including a detection circuit having a first detection resistor and a second detection resistor, and a buck-boost circuit of an H-bridge structure. Specifically, the buck-boost circuit includes a first bridge arm, a second bridge arm, and an inductor, the inductor is located between the first bridge arm and the second bridge arm, and two ends of the first bridge arm are connected to two ends of the second bridge arm in a one-to-one correspondence. One end of the first bridge arm is connected to one input end of the buck-boost circuit through the first detection resistor, and the other end of the first bridge arm is connected to the other input end of the buck-boost circuit. One end of the second bridge arm is connected to one output end of the buck-boost circuit through the second detection resistor, and the other end of the second bridge arm is connected to the other output end of the buck-boost circuit. and further help shorten a detection latency of the inductor current.

According to a first aspect, an embodiment of this application provides a voltage conversion circuit, mainly including a detection circuit having a first detection resistor and a second detection resistor, and a buck-boost circuit of an H-bridge structure. Specifically, the buck-boost circuit includes a first bridge arm, a second bridge arm, and an inductor, the inductor is located between the first bridge arm and the second bridge arm, and two ends of the first bridge arm are connected to two ends of the second bridge arm in a one-to-one correspondence. One end of the first bridge arm is connected to one input end of the buck-boost circuit through the first detection resistor, and the other end of the first bridge arm is connected to the other input end of the buck-boost circuit. One end of the second bridge arm is connected to one output end of the buck-boost circuit through the second detection resistor, and the other end of the second bridge arm is connected to the other output end of the buck-boost circuit.

The detection circuit may separately perform voltage sampling on a first resistor voltage of the first detection resistor and a second resistor voltage of the second detection resistor, and the detection circuit may further output a current detection signal based on a maximum voltage in the first resistor voltage and the second resistor voltage. The maximum voltage in the first resistor voltage and the second resistor voltage is a voltage of a detection resistor through which an inductor current of the inductor passes, and the current detection signal is used to indicate a value of the inductor current.

Specifically, in an inductor charging phase of buck conversion of the buck-boost circuit, an inductor current may flow through the first detection resistor and the second detection resistor. In this case, both the first resistor voltage and the second resistor voltage are maximum voltages. In an inductor freewheeling phase of the buck conversion of the buck-boost circuit, an inductor current flows through only the second detection resistor and does not flow through the first detection resistor. In this case, the second resistor voltage is a maximum voltage. In an inductor charging phase of boost conversion of the buck-boost circuit, an inductor current flows through only the first detection resistor and does not flow through the second detection resistor. In this case, the first resistor voltage is a maximum voltage. In the inductor freewheeling phase of the boost conversion of the buck-boost circuit, an inductor current may flow through the first detection resistor and the second detection resistor. In this case, both the first resistor voltage and the second resistor voltage are maximum voltages.

It can be learned that, regardless of whether the buck-boost circuit performs boost conversion or buck conversion, at least one of the first detection resistor and the second detection resistor can transmit an inductor current. Therefore, the detection circuit can output the current detection signal based on the maximum voltage in the first resistor voltage and the second resistor voltage, so that the current detection signal can indicate the value of the inductor current.

In this embodiment of this application, one end of the first detection resistor may be connected to a high-potential input end of the buck-boost circuit, or may be connected to a low-potential input end of the buck-boost circuit. One end of the second detection resistor may be connected to a high-potential output end of the buck-boost circuit, or may be connected to a low-potential output end of the buck-boost circuit. This is not limited in this embodiment of this application.

When one end of the first detection resistor is connected to the low-potential input end of the buck-boost circuit, one end of the first bridge arm is connected to the low-potential input end of the buck-boost circuit through the first detection resistor, and the other end of the first bridge arm is connected to the high-potential input end of the buck-boost circuit. When one end of the second bridge arm is connected to the low-potential output end of the buck-boost circuit through the second detection resistor, the other end of the second bridge arm is connected to the high-potential output end of the buck-boost circuit.

In this case, potentials of two ends of the first detection resistor and potentials of two ends of the second detection resistor are all relatively low, and a common-mode voltage (voltage to earth) of two ends of each of the two detection resistors is relatively low. This helps improve sampling accuracy of the detection circuit for a resistor voltage.

Usually, the buck-boost circuit may further include an input capacitor, and the input capacitor may filter an input voltage of the buck-boost circuit. In this embodiment of this application, one end of the input capacitor is connected to the high-potential input end of the buck-boost circuit, the other end of the input capacitor is connected to the low-potential input end of the buck-boost circuit, and the first detection resistor is located between the input capacitor and the first bridge arm.

Specifically, because the input capacitor has a filtering function, if the first detection resistor is located between the low-potential input end of the buck-boost circuit and the input capacitor, that is, the input capacitor is connected to the low-potential input end of the buck-boost circuit through the first detection resistor, a current passing through the first detection resistor is an average current of an inductor current. This implementation does not help detect a real-time inductor current. However, when the first detection resistor is located between the first bridge arm and the input capacitor, a filtering function of the input capacitor does not affect a current passing through the first detection resistor, that is, the current passing through the first detection resistor may be a real-time inductor current. Therefore, this helps detect the real-time inductor current by using a resistor voltage of the first detection resistor.

Similarly, the buck-boost circuit may further include an output capacitor, one end of the output capacitor is connected to the high-potential output end of the buck-boost circuit, the other end of the output capacitor is connected to the low-potential output end of the buck-boost circuit, and the second detection resistor is located between the output capacitor and the second bridge arm. This implementation helps detect a real-time inductor current by using a resistor voltage of the second detection resistor.

Next, the detection circuit is further described by using examples. In this embodiment of this application, the detection circuit may further include a first sampling circuit, a second sampling circuit, and a combiner circuit. The first sampling circuit is separately connected to the two ends of the first detection resistor and the combiner circuit, and the second sampling circuit is separately connected to the two ends of the second detection resistor and the combiner circuit. The first sampling circuit may output a first sampled signal to the combiner circuit based on the first resistor voltage of the first detection resistor, where a voltage of the first sampled signal meets a positive correlation with the first resistor voltage. The second sampling circuit may output a second sampled signal to the combiner circuit based on the second resistor voltage of the second detection resistor, where a voltage of the second sampled signal meets a positive correlation with the second resistor voltage. The combiner circuit may output the current detection signal based on a maximum voltage in the first sampled signal and the second sampled signal.

In this embodiment of this application, a same positive correlation relationship should be met between the first sampled signal and the first resistor voltage and between the second sampled signal and the second resistor voltage, to ensure that a relative value relationship between the first resistor voltage and the second resistor voltage can be determined by comparing the first sampled signal and the second sampled signal.

For example, the first sampling circuit may include a first operational amplifier circuit, one input end of the first operational amplifier circuit is connected to one end of the first detection resistor, the other input end of the first operational amplifier circuit is connected to the other end of the first detection resistor, and an output end of the first operational amplifier circuit is configured to output the first sampled signal. Usually, the voltage of the first sampled signal is positive. A non-inverting input end of the first operational amplifier circuit may be connected to a high-potential end of the first detection resistor, and an inverting input end of the first operational amplifier circuit may be connected to a low-potential end of the first detection resistor.

For example, the second sampling circuit may include a second operational amplifier circuit, one input end of the second operational amplifier circuit is connected to one end of the second detection resistor, the other input end of the second operational amplifier circuit is connected to the other end of the second detection resistor, and an output end of the second operational amplifier circuit is configured to output the second sampled signal. Usually, the voltage of the second sampled signal is positive. A non-inverting input end of the second operational amplifier circuit may be connected to a high-potential end of the second detection resistor, and an inverting input end of the second operational amplifier circuit may be connected to a low-potential end of the second detection resistor.

For example, the combiner circuit may include a first diode and a second diode. An anode of the first diode is connected to the first sampling circuit, an anode of the second diode is connected to the second sampling circuit, a cathode of the first diode is connected to a cathode of the second diode through a first connection point, and the first connection point may output the current detection signal.

Specifically, because the cathode of the first diode is connected to the cathode of the second diode, a diode with a larger anode voltage may cause a diode with a lower anode voltage to be cut off. In this embodiment of this application, an anode voltage of the first diode is the voltage of the first sampled signal, and an anode voltage of the second diode is the voltage of the second sampled signal. Therefore, when the voltage of the first sampled signal is greater than the voltage of the second sampled signal, the first diode is conducted, so that a voltage of the first connection point is the voltage of the first sampled signal. Likewise, when the voltage of the second sampled signal is greater than the voltage of the first sampled signal, the second diode is conducted, so that a voltage of the first connection point is the voltage of the second sampled signal.

It can be learned that the voltage of the first sampling point is a larger voltage in the first sampled signal and the second sampled signal, and the positive correlations respectively exist between the first sampled signal and the second sampled signal and the first resistor voltage and the second resistor voltage. Therefore, a positive correlation exists between the larger voltage in the first sampled signal and the second sampled signal and the inductor current, and the voltage of the first sampling point can be used as the current detection signal to indicate the value of the inductor current.

To further improve detection accuracy of the inductor current, in a possible implementation, the combiner circuit may further include a third operational amplifier circuit and a fourth operational amplifier circuit. One input end of the fourth operational amplifier circuit is connected to the second sampling circuit, and is configured to receive the second sampled signal; the other input end of the fourth operational amplifier circuit is connected to the cathode of the second diode, and an output end of the fourth operational amplifier circuit is connected to the anode of the second diode; one input end of the third operational amplifier circuit is connected to the first sampling circuit, and is configured to receive the first sampled signal; and the other input end of the third operational amplifier circuit is connected to the cathode of the first diode, and an output end of the third operational amplifier circuit is connected to the anode of the first diode.

The third operational amplifier circuit is used as an example. Voltages of the two input ends of the third operational amplifier circuit are respectively the voltage of the first sampled signal and a cathode voltage of the first diode. According to a "virtual short circuit" characteristic of the operational amplifier circuit, that is, the voltages of the two input ends of the third operational amplifier circuit are equal, the voltage of the first sampled signal can be kept equal to the cathode voltage of the first diode, thereby achieving a voltage following effect. Likewise, the fourth operational amplifier circuit can keep the voltage of the second sampled signal equal to a cathode voltage of the second diode. Therefore, the voltage of the first connection point can be kept equal to the voltage of the first sampled signal or the voltage of the second sampled signal, thereby further improving current detection accuracy.

In a possible implementation, the combiner circuit may further include a ground resistor, one end of the ground resistor is connected to the first connection point, and the other end of the ground resistor is grounded. The ground resistor is disposed, so that the voltage of the first connection point can be prevented from being locked at 0 V

It should be understood that this embodiment of this application is applicable to a plurality of types of buck-boost circuits. For example, the buck-boost circuit may include a plurality of first bridge arms, a plurality of second bridge arms, and a plurality of inductors. The plurality of first bridge arms are connected in parallel, the plurality of second bridge arms are connected in parallel, and the plurality of inductors are connected to the plurality of first bridge arms and the plurality of second bridge arms in a one-to-one correspondence. One end of each inductor is connected to a first bridge arm corresponding to each inductor, and the other end of each inductor is connected to a second bridge arm corresponding to each inductor. In this case, the detection circuit may detect a sum of inductor currents of the plurality of inductors through the first detection resistor and the second detection resistor.

According to a second aspect, an embodiment of this application provides a voltage converter, mainly including a controller and the voltage conversion circuit provided in any one of the first aspect and the possible implementations of the first aspect. The controller may control the voltage conversion circuit to perform voltage conversion.

According to a third aspect, an embodiment of this application provides an electronic device, mainly including the voltage converter provided in the second aspect.

**BRIEF DESCRIPTION OF DRAWINGS**

FIG. 1 is a schematic diagram of a structure of a voltage converter;
FIG. 2a is a schematic diagram of a structure of a buck-boost circuit;
FIG. 2b to FIG. 2e are schematic diagrams of a switching status of a buck-boost circuit;
FIG. 3 is a schematic diagram of a structure of a voltage converter according to an embodiment of this application;
FIG. 4 is a schematic diagram of a structure of a buck-boost circuit according to an embodiment of this application;
FIG. 5a is a schematic diagram of current changes in detection resistors according to an embodiment of this application;
FIG. 5b is a schematic diagram of a switching status of a buck-boost circuit according to an embodiment of this application;
FIG. 5c is a schematic diagram of a switching status of a buck-boost circuit according to an embodiment of this application;
FIG. 6a is a schematic diagram of current changes in detection resistors according to an embodiment of this application;
FIG. 6b is a schematic diagram of a switching status of a buck-boost circuit according to an embodiment of this application;
FIG. 6c is a schematic diagram of a switching status of a buck-boost circuit according to an embodiment of this application;
FIG. 7 is a schematic diagram of a structure of a detection circuit according to an embodiment of this application; and
FIG. 8 is a schematic diagram of a structure of a combiner circuit according to an embodiment of this application.

**DESCRIPTION OF EMBODIMENTS**

To make the objectives, technical solutions, and advantages of this application clearer, the following further describes this application in detail with reference to the accompanying drawings. It should be noted that, in description of this application, "at least one" means one or more, and "a plurality of" means two or more. In view of this, "a plurality of" may also be understood as "at least two" in embodiments of the present invention. The term "and/or" describes an association relationship for describing associated objects and indicates that three relationships may exist. For example, A and/or B may indicate the following three cases: Only A exists, both A and B exist, and only B exists. In addition, unless otherwise specified, the character "/" usually indicates an "or" relationship between associated objects. In addition, it should be understood that in the descriptions of this application, terms such as "first" and "second" are merely used for distinguishing and description, but should not be understood as indicating or implying relative importance, or should not be understood as indicating or implying a sequence.

It should be noted that the "connection" in embodiments of this application refers to an electric connection, and the connection between two electrical elements may be a direct or indirect connection between the two electrical elements. For example, a connection between A and B may represent that A and B are directly connected to each other, or A and B are indirectly connected to each other by using one or more other electrical elements. For example, the connection between A and B may also represent that A is directly connected to C, C is directly connected to B, and A and B are connected to each other through C. In some scenarios, "connection" may also be understood as coupling, such as electromagnetic coupling between two inductors. In conclusion, A is connected to B, so that electric energy can be transmitted between A and B.

The following further describes in detail this application.

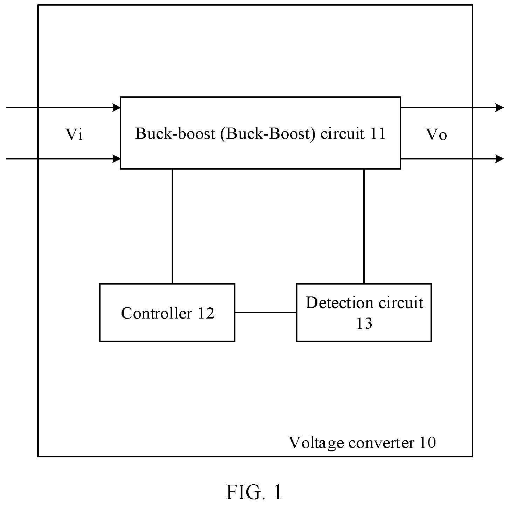

A buck-boost circuit is a common voltage (current) conversion circuit, and can implement both buck conversion and boost conversion. Therefore, the buck-boost circuit may be applied to voltage converters in many power systems. FIG. 1 shows an example of a voltage converter. As shown in FIG. 1, a voltage converter 10 mainly includes a buck-boost circuit 11, a controller 12, and a detection circuit 13. The Buck- Boost circuit 11 is separately connected to the controller 12 and the detection circuit 13, and the controller 12 is connected to the detection circuit 13. Specifically:

Buck-boost circuit 11

The buck-boost circuit 11 is also commonly referred to as a buck-boost conversion circuit. Specifically, when the buck-boost circuit 11 performs buck conversion, an input voltage Vi of the buck-boost circuit 11 is greater than an output voltage Vo. When the buck-boost circuit 11 performs boost conversion, an input voltage Vi of the buck-boost circuit is less than an output voltage Vo.

The buck-boost circuit 11 can implement both buck conversion and boost conversion, so that the voltage converter 10 having the buck-boost circuit 11 is widely applied to many power systems. For example, the voltage converter 10 may be a power electronic converter in a power management system of an electric/a hybrid vehicle, may be a battery management system (battery management system, BMS) in a photovoltaic power generation system, or may be a direct current distribution unit in a communications power supply system, or the like. Examples are not listed one by one in this application.

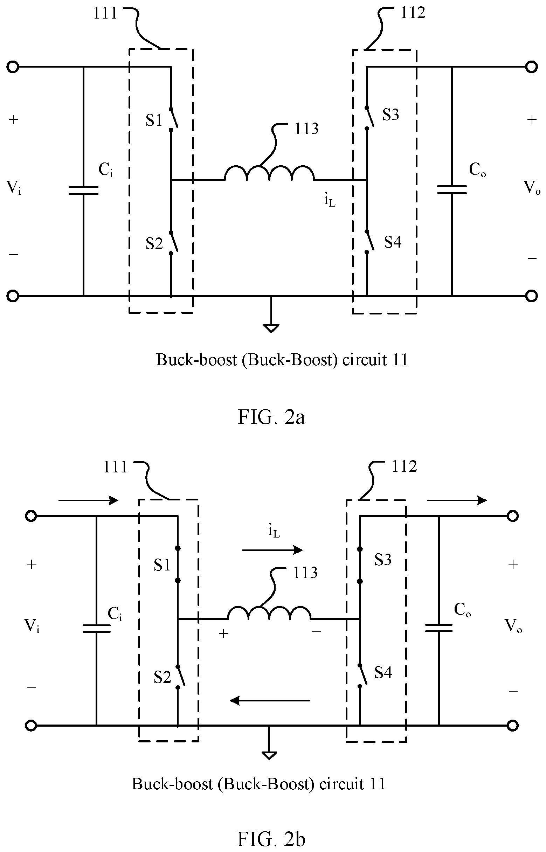

For example, FIG. 2a is a schematic diagram of a structure of a buck-boost circuit. As shown in FIG. 2a, the buck-boost circuit 11 has an H-bridge structure. The buck-boost circuit 11 mainly includes a bridge arm 111, a bridge arm 112, and an inductor 113, and the inductor 13 is located between the bridge arm 111 and the bridge arm 112.

In the buck-boost circuit 11, the bridge arm 111 and the bridge arm 112 mainly include a plurality of switching transistors. Charging or discharging of the inductor 113 may be adjusted by changing conduction or opening of the switching transistors. For example, as shown in FIG. 2a, the bridge arm 111 includes a switching transistor S1 and a switching transistor S2, a second electrode of the switching transistor S1 is connected to a first electrode of the switching transistor S2, and a first electrode of the switching transistor S1 and a second electrode of the switching transistor S2 may receive an input voltage $V_i$. The bridge arm 112 includes a switching transistor S3 and a switching transistor S4, a second electrode of the switching transistor S3 is connected to a first electrode of the switching transistor S4, and a first electrode of the switching transistor S3 and a second electrode of the switching transistor S4 may output an output voltage $V_o$. One end of the inductor 113 is connected to the second electrode of the switching transistor S1, and the other end of the inductor 13 is connected to the second electrode of the switching transistor S4.

Usually, the buck-boost circuit 11 may further include an input capacitor $C_i$. One end of the input capacitor $C_i$ is connected to a high-potential input end of the buck-boost circuit 11, and the other end of the input capacitor $C_i$ is connected to a low-potential input end of the buck-boost circuit 11. The input capacitor $C_i$ may filter the input voltage $V_i$ to reduce a ripple of the input voltage $V_i$.

In addition, the buck-boost circuit 11 may further include an output capacitor $C_o$. One end of the input capacitor $C_o$ is connected to a high-potential output end of the buck-boost circuit 11, and the other end of the input capacitor $C_o$ is connected to a low-potential output end of the buck-boost circuit 11. The output capacitor $C_o$ may filter the output voltage $V_o$, so that the buck-boost circuit 11 can further continuously output stable output voltages $V_o$.

Based on the buck-boost circuit 11 shown in FIG. 2a, voltage conversion of the buck-boost circuit 11 may be implemented by controlling the switching transistor S1 to the switching transistor S4 to be cyclically conducted or opened.

During buck conversion, each cycle mainly includes the following phases:

Inductor charging phase: States of the switching transistors in the buck-boost circuit 11 may be shown in FIG. 2b. The switching transistor S1 and the switching transistor S3 are conducted, and the switching transistor S2 and the switching transistor S4 are open.

An arrow in FIG. 2b shows a current transmission direction. As shown in FIG. 2b, a current is input from the high-potential input end of the buck-boost circuit 11, sequentially flows through the switching transistor S1, the inductor 113, and the switching transistor S3, and is output from the high-potential output end of the buck-boost circuit 11 through the first electrode of the switching transistor S3; and a returning current is input from the low-potential output end of the buck-boost circuit 11, and is output from the low-potential input end of the buck-boost circuit 11.

In this case, one end that is of the inductor 113 and that is near the switching transistor S1 is at a high potential, and the potential of the end is equal to a potential of the high-potential input end of the buck-boost circuit 11. In this case, the other end that is of the inductor 113 and that is near the switching transistor S3 is at a low potential, and the potential of the end is equal to a potential of the high-potential output end of the buck-boost circuit 11. Because the low-potential input end of the buck-boost circuit 11 is equipotentially connected to the low-potential output end, a voltage of the inductor 113 is $V_i$-$V_o$.

The voltage of the inductor 113 may be understood as a potential difference obtained by subtracting the potential of the other end that is of the inductor 113 and that is near the switching transistor S3 from the potential of the end that is of the inductor 113 and that is near the switching transistor S1. For ease of description, in subsequent embodiments, a voltage of the inductor 113 can be likewise understood, and is not described in detail again.

A current flowing through the inductor 113 may also be referred to as an inductor current $i_L$. Because the inductor current $i_L$ cannot be instantly increased, the inductor current $i_L$ gradually increases after the switching transistor S1 and the switching transistor S3 are conducted. In addition, because the input voltage $V_i$ is greater than the output voltage $V_o$ during buck conversion, in this process, the voltage $V_i$-$V_o$ of the inductor 113 is greater than 0, and the inductor 113 is charged.

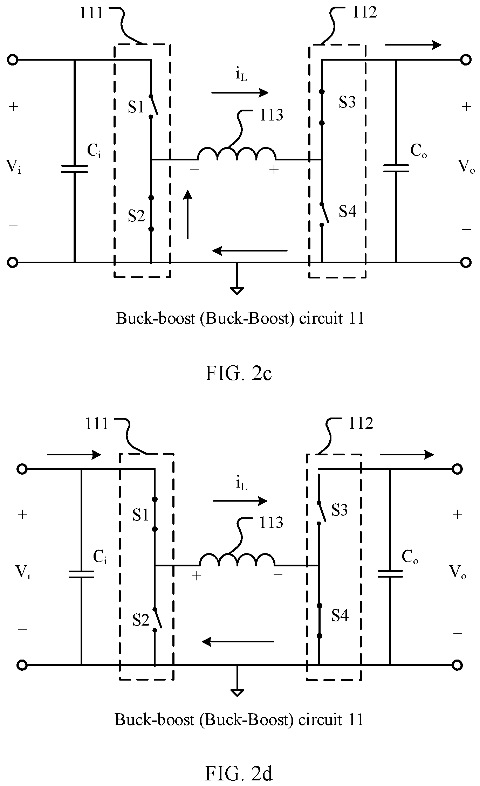

Inductor freewheeling phase: States of the switching transistors in the buck-boost circuit 11 may be shown in FIG. 2c. The switching transistor S1 is open, the switching transistor S2 is conducted, the switching transistor S3 is kept conducted, and the switching transistor S4 is kept open.

An arrow in FIG. 2c shows a current transmission direction. As shown in FIG. 2c, a current is output from the other end that is of the inductor 113 and that is near the switching transistor S3, and is output from the high-potential output end of the buck-boost circuit 11 through the first electrode of the switching transistor S3. A returning current is input from the low-potential output end of the buck-boost circuit 11, and is returned, through the switching transistor S2, to the end that is of the inductor 113 and that is near the switching transistor S1.

In this case, the end that is of the inductor 113 and that is near the switching transistor S1 is at a low potential, and the low potential of the end is equal to a potential of the low-potential output end of the buck-boost circuit 11. The other end that is of the inductor 113 and that is near the switching transistor S3 is at a high potential, and the potential of the end is equal to a potential of the high-potential output end of the buck-boost circuit 11. Further, it can be learned that a voltage of the inductor 113 is -$V_o$.

Because an inductor current $i_L$ cannot be instantly zeroed, the inductor current $i_L$ gradually decreases after the switching transistor S1 is open. In addition, because the voltage of the inductor 113 is -$V_o$ in this case, the inductor 113 starts to discharge. This process may also be referred to as inductor 113 freewheeling. An inductor current $i_L$ output by the inductor 113 is output through the switching transistor S3.

Assuming that duration of the inductor charging phase and duration of the inductor discharging phase are equal and are both t, it can be learned according to a volt-second balance principle that $(V_i$-$V_o)t$-$V_ot$=0. Further, it can be learned that $V_o$=$V_i$/2. Therefore, buck conversion of the buck-boost circuit 11 can be implemented by using the inductor charging phase and the inductor discharging phase.

During boost conversion, each cycle mainly includes the following phases:

Inductor charging phase: States of the switching transistors in the buck-boost circuit 11 may be shown in FIG. 2d. The switching transistor S1 and the switching transistor S4 are conducted, and the switching transistor S2 and the switching transistor S3 are open.

An arrow in FIG. 2d shows a current transmission direction. As shown in FIG. 2d, a current is input from a first electrode of the switching transistor S1, sequentially flows through the switching transistor S1, the inductor 113, and the switching transistor S4, and is output from the low-potential input end of the buck-boost circuit 11.

In this case, the end that is of the inductor 113 that is near the switching transistor S1 is at a high potential, and the potential of the end is equal to a potential of the high-potential input end of the buck-boost circuit 11. The other end that is of the inductor 113 that is near the switching transistor S3 is at a low potential, and the potential of the end is equal to a potential of the low-potential input end of the buck-boost circuit 11. Therefore, a voltage of the inductor 113 is $V_i$.

In this phase, the inductor 113 is charged, the output capacitor $C_o$ is discharged, and the output voltage $V_o$ is equal to a voltage of the output capacitor $C_o$.

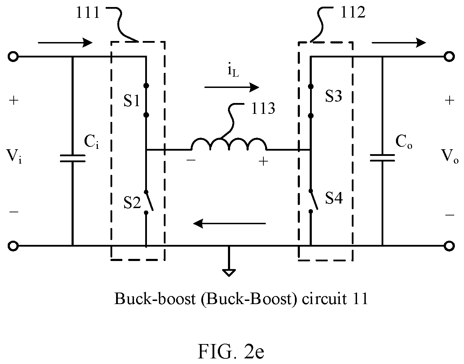

Inductor discharging phase: States of the switching transistors in the buck-boost circuit 11 may be shown in FIG. 2e. The switching transistor S3 is conducted, the switching transistor S4 is open, the switching transistor S1 is kept conducted, and the switching transistor S2 is kept opening.

An arrow in FIG. 2e shows a current transmission direction. As shown in FIG. 2e, a current is input from the high-potential input end of the buck-boost circuit 11, and is output from the high-potential output end of the buck-boost circuit 11 through the switching transistor S3 after being transmitted through the inductor 113. A returning current is input from the low-potential output end of the buck-boost circuit 11, and is output from the low-potential input end of the buck-boost circuit 11.

In this case, the end that is of the inductor 113 and that is near the switching transistor S1 is at a low potential, and the potential of the end is equal to a potential of the high-potential output end of the buck-boost circuit 11. The end that is of the inductor 113 and that is near the switching transistor S3 is at a high potential, and the potential of the end is equal to a potential of the high-potential output end of the buck-boost circuit 11. Because the low-potential input end of the buck-boost circuit 11 is equipotentially connected to the low-potential output end, a voltage of the inductor 113 is $V_i$-$V_o$.

Because an inductor current $i_L$ cannot be instantly zeroed, the inductor current $i_L$ gradually decreases after the switching transistor S1 and the switching transistor S3 are conducted. In addition, because the input voltage $V_i$ is less than the output voltage $V_o$ during boost conversion, in this process, the voltage $V_i$-$V_o$ of the inductor 113 is less than 0, and the inductor 113 is discharged.

Assuming that duration of the inductor charging phase and duration of the inductor discharging phase are equal and are both t, it can be learned according to the volt-second balance principle that $V_it$+$(V_i$-$V_o)t$=0. Further, it can be learned that $V_o$=$2V_i$. Therefore, boost conversion of the buck-boost circuit 11 can be implemented by using the inductor charging phase and the inductor discharging phase.

Controller 12

The controller 12 may separately provide a same control signal or different control signals for the switching transistors S1 to S4, to separately control the switching transistors S1 to S4 to be conducted or open. Further, the foregoing voltage conversion of the buck-boost circuit 11 can be implemented. For example, the controller 12 may be a logic circuit capable of generating a control signal. For example, the controller 12 may be a general-purpose central processing unit (central processing unit, CPU), a general-purpose processor, digital signal processor (digital signal processing, DSP), or an application-specific integrated circuit (application-specific integrated circuits, ASIC), a field programmable gate array (field programmable gate array, FPGA), a microcontroller unit (microcontroller unit, MCU), another programmable logic device, a transistor logic device, a hardware component, or any combination thereof.

Detection circuit 13

The detection circuit 13 may detect an operating status of the buck-boost circuit 11, and feed back detected operating status information to the controller 12, so that the controller 12 can adjust, based on the operating state information of the buck-boost circuit 11, control signals provided for the switching transistor S1 to the switching transistor S4. That is, the controller 12 can implement closed-loop control on the buck-boost circuit 11 by using the detection circuit 13.

In some application scenarios of the buck-boost circuit 11, an inductor current $i_L$ in the buck-boost circuit 11 usually needs to be detected by using the detection circuit 13. For example, the inductor current $i_L$ detected by the detection circuit 13 may be used for closed-loop control. The controller 12 may adjust, based on the inductor current $i_L$ detected by the detection circuit 13, control signals provided for the switching transistors S1 to S4, to implement closed-loop control.

In addition, the inductor current detected by the detection circuit 13 may be used for over current protection (over current protection, OCP). For example, when the inductor current $i_L$ detected by the detection circuit 13 exceeds a current threshold, the controller 12 may control the buck-boost circuit 11 to stop performing voltage conversion on the input voltage $V_i$.

It may be understood that the foregoing describes only two common application scenarios of the inductor current $i_L$, and other possible application scenarios are not listed one by one in this application.

In some current detection solutions, the detection circuit 13 mainly includes a current sensor, and the current sensor is a Hall element connected to the inductor 113 in series. When the inductor 113 is charged or discharged, an output signal of the current sensor changes. Therefore, the controller 12 can determine a value of a current inductor current $i_L$ based on an output signal of the current sensor.

However, at present, costs of most current sensors are relatively high. This does not help save costs of the voltage converter 10. In addition, because the current sensor detects an inductor current $i_L$ based on the Hall effect, a detection latency of the current sensor is relatively large, and consequently application of the inductor current $i_L$ in some scenarios is limited. For example, in an OCP scenario, because a detection latency of the current sensor is relatively large, it is possible that when the inductor current $i_L$ is excessively large, the controller 12 cannot immediately control the buck-boost circuit 11 to stop operating, and consequently a damage risk of the buck-boost circuit 11 is increased.

In view of this, an embodiment of this application provides a detection circuit, and the detection circuit includes a first detection resistor and a second detection resistor. The first detection resistor and the second detection resistor may be connected to a buck-boost circuit. Regardless of whether the buck-boost circuit is in any one of the states shown in FIG. 2b to FIG. 2e, an inductor current $i_L$ can flow through at least one of the first detection resistor and the second detection resistor. Therefore, the detection circuit can detect the inductor current $i_L$ based on the first detection resistor and the second detection resistor.

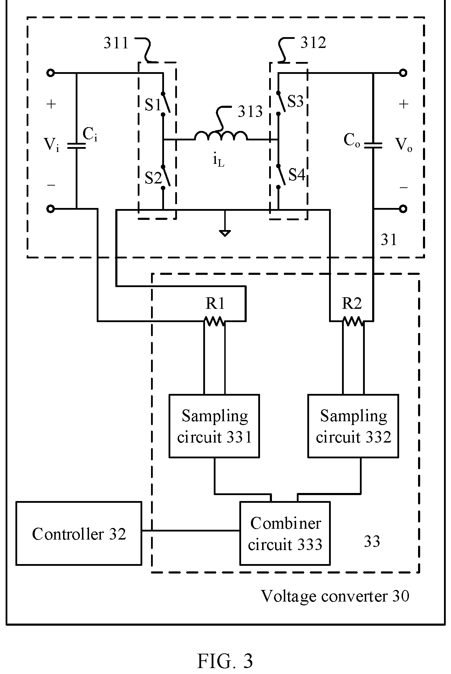

FIG. 3 is a schematic diagram of an example structure of a voltage converter according to an embodiment of this application. As shown in FIG. 3, a voltage converter 30 mainly includes a buck-boost circuit 31 and a detection circuit 33. In a possible implementation, the voltage converter 30 may further include a controller 32, and the controller 32 may control the buck-boost circuit 31 to perform voltage conversion. In addition, the controller 32 may also receive a current detection signal provided by the detection circuit 33. A specific implementation of the controller 32 is similar to that of the foregoing controller 12, and is not described in detail herein.

As shown in FIG. 3, the buck-boost circuit 31 has an H-bridge structure, including a bridge arm 311, a bridge arm 312, and an inductor 313, and the inductor 313 is located between the bridge arm 311 and the bridge arm 312. It can be learned from FIG. 3 that the H-bridge structure in the buck-boost circuit 31 mainly includes the inductor 313, the bridge arm 311, and the bridge arm 312, and the H-bridge structure is similar to the H-bridge structure (mainly including the inductor 113, the bridge arm 111, and the bridge arm 112) in the buck-boost circuit 11. Repeated parts are not described again.

In this embodiment of this application, a switching transistor S1 to a switching transistor S4 each may be one or more of a plurality of types of switching transistors, such as a relay, a metal-oxide-semiconductor field-effect transistor (metal oxide semiconductor field effect transistor, MOSFET), a bipolar junction transistor (bipolar junction transistor, BJT), and an insulated gate bipolar transistor (insulated gate bipolar transistor, IGBT). Examples are not listed one by one in this embodiment of this application.

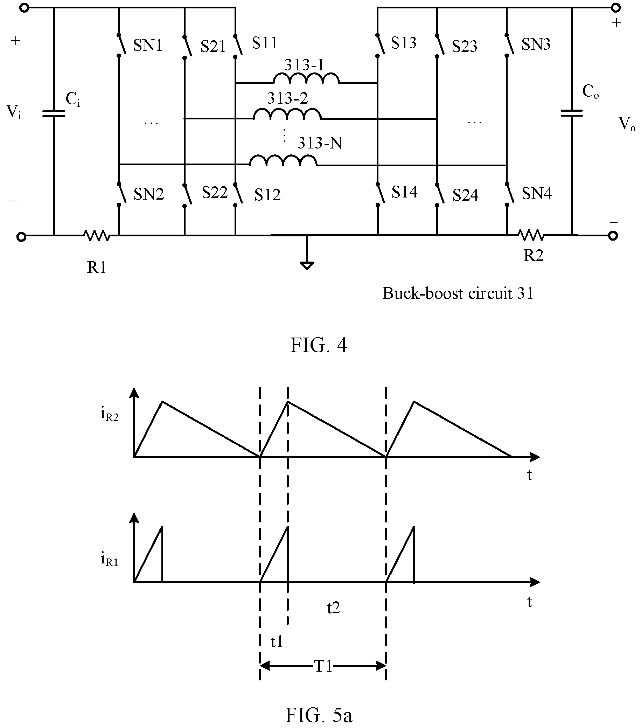

It should be noted that the H-bridge structure in the buck-boost circuit 31 in FIG. 3 is merely an example. In a specific implementation structure, the buck-boost circuit 31 may be alternatively implemented in another type of manner. For example, as shown in FIG. 4, the bridge arm 311 may include N first bridge arms 311, N second bridge arms 312, and N inductors 113 (an inductor 113-1 to an inductor 113-N), where N is an integer greater than or equal to 1.

Specifically, a switching transistor S11 and a switching transistor S12 belong to a same first bridge arm, a switching transistor S21 and a switching transistor S22 belong to a same first bridge arm, ..., and a switching transistor SN1 and a switching transistor SN2 belong to a same first bridge arm. A switching transistor S13 and a switching transistor S14 belong to a same second bridge arm, a switching transistor S23 and a switching transistor S24 belong to a same second bridge arm, ..., and a switching transistor SN3 and a switching transistor SN4 belong to a same second bridge arm.

As shown in FIG. 4, the N first bridge arms are connected in parallel, and the N second bridge arms are connected in parallel. Specifically, a first electrode of the switching transistor S11 to a first electrode of the switching transistor SN1 are all connected to a high-potential input end of the buck-boost circuit 31, a first electrode of the switching transistor S12 to a second electrode of the switching transistor SN2 are all connected to a low-potential input end of the buck-boost circuit 31, a first electrode of the switching transistor S13 to a first electrode of the switching transistor SN3 are all connected to a high-potential output end of the buck-boost circuit 31, and a first electrode of the switching transistor S14 to a second electrode of the switching transistor SN4 are all connected to a low-potential output end of the buck-boost circuit 31.

The N inductors in the buck-boost circuit 31 are connected to the N first bridge arms and the N second bridge arms in a one-to-one correspondence, one end of each inductor is connected to a corresponding first bridge arm, and the other end of each inductor is connected to a corresponding second bridge arm. For example, in FIG. 4, one end of the inductor 313-1 is connected to the first bridge arm in which the switching transistor S11 and the switching transistor S12 are located, and the other end of the inductor 313-1 is connected to the second bridge arm in which the switching transistor S13 and the switching transistor S14 are located. One end of the inductor 313-2 is connected to the first bridge arm in which the switching transistor S21 and the switching transistor S22 are located, and the other end of the inductor 313-2 is connected to the second bridge arm in which the switching transistor S23 and the switching transistor S24 are located. One end of the inductor 313-N is connected to the first bridge arm in which the switching transistor SN1 and the switching transistor SN2 are located, and the other end of the inductor 313-N is connected to the second bridge arm in which the switching transistor SN3 and the switching transistor SN4 are located.

For ease of understanding, next, this embodiment of this application provides descriptions by using, as an example, the buck-boost circuit 31 shown in FIG. 3. It should be noted that this embodiment of this application is also applicable to a scenario in which the buck-boost circuit 31 includes two or more inductors 313.

As shown in FIG. 3, the detection circuit 33 includes a detection resistor R1 and a detection resistor R2. One end of the detection resistor R1 is connected to one input end of the buck-boost circuit 31, the other end of the detection resistor R1 is connected to one end of the bridge arm 311, and the other end of the bridge arm 311 is connected to the other input end of the buck-boost circuit 31. One end of the detection resistor R2 is connected to one output end of the buck-boost circuit 31, the other end of the detection resistor R2 is connected to one end of the bridge arm 312, and the other end of the bridge arm 312 is connected to the other output end of the buck-boost circuit 31.

One of the two input ends of the buck-boost circuit 31 is the high-potential input end, and the other is the low-potential input end. A potential difference obtained after subtracting a potential of the low-potential input end from a potential of the high-potential input end is an input voltage $V_i$. One of the two output ends of the buck-boost circuit 31 is the high-potential output end, and the other is the low-potential output end. A potential difference obtained after subtracting a potential of the low-potential output end from a potential of the high-potential output end is an output voltage $V_o$.

In this embodiment of this application, "one end of the detection resistor R1 is connected to one input end of the buck-boost circuit 31, the other end of the detection resistor R1 is connected to one end of the bridge arm 311" may be understood that a first electrode of the switching transistor S1 in the bridge arm 311 is connected to the high-potential input end of the buck-boost circuit 31 through the detection resistor R1. In this case, a second electrode of the switching transistor S2 is connected to the low-potential input end of the buck-boost circuit 31.

"One end of the detection resistor R1 is connected to one input end of the buck-boost circuit 31, the other end of the detection resistor R1 is connected to one end of the bridge arm 311" may be alternatively understood that a second electrode of the switching transistor S2 in the bridge arm 311 is connected to the low-potential input end of the buck-boost circuit 31 through the detection resistor R1. In this case, a first electrode of the switching transistor S1 in the bridge arm 311 is connected to the high-potential input end of the buck-boost circuit 31.

Connection relationships between the detection resistor R2 and one output end of the buck-boost circuit 31 and one end of the bridge arm 312 can be likewise understood, and are not described in detail.

If one end of the detection resistor R1 is connected to the low-potential input end of the buck-boost circuit 31 and one end of the detection resistor R2 is connected to the low-potential output end of the buck-boost circuit 31, potentials of the two ends of the detection resistor R1 and potentials of the two ends of the detection resistor R2 are all relatively low, and a common-mode voltage (voltage to earth) of two ends of each of the two detection resistors is relatively low. This helps improve sampling accuracy of the detection circuit 33 for a resistor voltage.

In this embodiment of this application, as shown in FIG. 3, the buck-boost circuit 31 may further include an input capacitor $C_i$. One end of the input capacitor $C_i$ is connected to the high-potential input end of the buck-boost circuit 31, and the other end of the input capacitor $C_i$ is connected to the low-potential input end of the buck-boost circuit 31.

In this case, the detection resistor R1 may be located between the input capacitor $C_i$ and the bridge arm 311. For example, in FIG. 3, one end of the detection resistor R1 is further connected to the other end of the input capacitor $C_i$, and the other end of the detection resistor R1 is connected to the second electrode of the switching transistor S2 in the bridge arm 311.

Specifically, because the input capacitor $C_i$ has a filtering function, if the detection resistor R1 is located between the low-potential input end of the buck-boost circuit 31 and the input capacitor $C_i$, that is, the input capacitor $C_i$ is connected to the low-potential input end of the buck-boost circuit 31 through the detection resistor R1, a current passing through the detection resistor R1 is an average current of an inductor current $i_L$. In this case, the average current of the inductor current $i_L$ can be detected by using a resistor voltage of the detection resistor R1, but this implementation does not help detect a real-time inductor current $i_L$.

However, when the detection resistor R1 is located between the bridge arm 311 and the input capacitor $C_i$, a filtering function of the input capacitor $C_i$ does not affect a current passing through the detection resistor R1, that is, the current passing through the detection resistor R1 may be a real-time inductor current $i_L$. Therefore, this helps detect the real-time inductor current $i_L$ by using a resistor voltage of the detection resistor R1.

Similarly, the buck-boost circuit 31 may further include an output capacitor $C_o$. One end of the output capacitor $C_o$ is connected to the high-potential output end of the buck-boost circuit 31, and the other end of the output capacitor $C_o$ is connected to the low-potential output end of the buck-boost circuit 31.

In this case, the detection resistor R2 may be located between the bridge arm 312 and the output capacitor $C_o$. For example, in FIG. 3, one end of the detection resistor R2 is further connected to the other end of the output capacitor $C_o$, and the other end of the detection resistor R1 is connected to a second electrode of the switching transistor S4 in the bridge arm 312. This implementation helps detect a real-time inductor current $i_L$ by using a resistor voltage of the detection resistor R2, and details not described.

Based on the detection resistor R1 and the detection resistor R2, regardless of whether the buck-boost circuit 31 performs boost conversion or buck conversion, an inductor current $i_L$ can pass through at least one of the detection resistor R1 and the detection resistor R2, so that the detection circuit 33 can detect a value of the inductor current $i_L$ by using resistor voltages of the detection resistor R1 and the detection resistor R2.

As shown in FIG. 3, the detection circuit 33 is separately connected to the detection resistor R1 and the detection resistor R2. Specifically, the detection circuit 33 is separately connected to the two ends of the detection resistor R1 and the two ends of the detection resistor R2. The detection circuit 33 may separately detect a resistor voltage $V_{R1}$ of the detection resistor R1 and a resistor voltage $V_{R2}$ of the detection resistor R2.

Further, the detection circuit 33 may output a current detection signal $V_a$ based on a maximum voltage in the resistor voltage $V_{R1}$ and the resistor voltage $V_{R2}$. The maximum voltage in the resistor voltage $V_{R1}$ and the resistor voltage $V_{R2}$ may be a voltage of a detection resistor through which an inductor current $i_L$ passes in the detection resistor R1 and the detection resistor R2. Therefore, the current detection signal $V_a$ output based on the maximum voltage in the resistor voltage $V_{R1}$ and the resistor voltage $V_{R2}$ can indicate a value of an inductor current $i_L$ passing through the detection resistor R1 and/or the detection resistor R2.

It should be noted that a resistance value of the detection resistor R1 is equal to a resistance value of the detection resistor R2. Based on positions of the detection resistor R1 and the detection resistor R2 in the buck-boost circuit 31, an equiproportional relationship is always kept between the maximum voltage in the resistor voltage $V_{R1}$ and the resistor voltage $V_{R2}$ and the inductor current $i_L$, and a ratio is the resistance value of the detection resistor R1 or the detection resistor R2.

Next, relationships existing between an inductor current $i_L$ and the detection resistor R1 and the detection resistor R2 when the buck-boost circuit 31 performs voltage conversion are further described by using examples.

Buck conversion

For example, FIG. 5a is a schematic diagram of current changes in the detection resistor R1 and the detection resistor R2 in a buck conversion process. A buck conversion cycle is T1, that is, the buck-boost circuit 31 can complete buck conversion once every T1 time. In FIG. 5a, each T1 includes two time periods t1 and t2, t1 represents an inductor charging phase in the buck conversion, and t2 represents an inductor freewheeling phase in the buck conversion. $i_{R2}$ represents a current flowing through the detection resistor R2, and $i_{R1}$ represents a current flowing through the detection resistor R1.

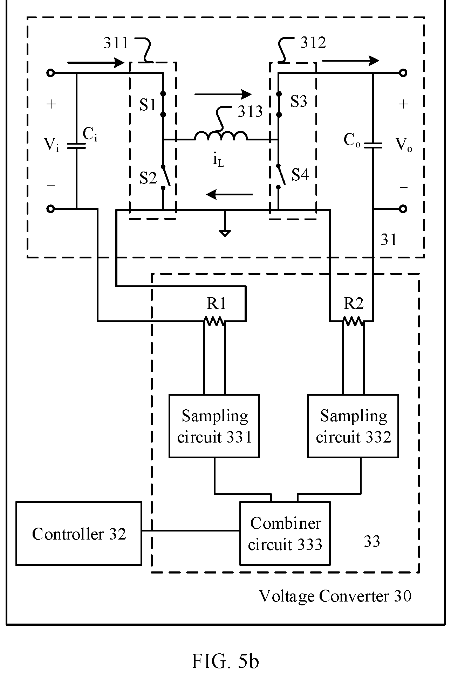

Inductor charging phase: As described above, refer to FIG. 5b. In the inductor charging phase of the buck conversion, the switching transistor S1 and the switching transistor S3 are conducted, and the switching transistor S2 and the switching transistor S4 are open. A current is input from the high-potential input end of the buck-boost circuit 31, sequentially flows through the switching transistor S1, the inductor 113, and the switching transistor S3, and is output from the high-potential output end of the buck-boost circuit 31 through a first electrode of the switching transistor S3. A returning current is input from the low-potential output end of the buck-boost circuit 31, sequentially flows through the detection resistor R2 and the detection resistor R1, and is output from the low-potential input end of the buck-boost circuit 31.

In this phase, the inductor 313, the detection resistor R2, and the detection resistor R1 are sequentially connected in series. Therefore, a current $i_{R1}$ flowing through the detection resistor R1 and a current $i_{R2}$ flowing through the detection resistor R2 are equal to an inductor current $i_L$. In the inductor charging phase of the buck conversion, the inductor current $i_L$ gradually increases. Therefore, as shown in FIG. 5a, in the time period t1, the current $i_{R1}$ flowing through the detection resistor R1 and the current $i_{R2}$ flowing through the detection resistor R2 also gradually increase.

Because the current $i_{R1}$ flowing through the detection resistor R1 and the current $i_{R2}$ flowing through the detection resistor R2 are equal to the inductor current $i_L$, and the resistance value of the detection resistor R1 is equal to the resistance value of the detection resistor R2, a resistor voltage $V_{R1}$ is equal to a resistor voltage $V_{R2}$ in the inductor charging phase of the buck conversion, a maximum voltage in the resistor voltage $V_{R1}$ and the resistor voltage $V_{R2}$ is the resistor voltage $V_{R1}$ and the resistor voltage $V_{R2}$, and ratios of the resistor voltage $V_{R1}$ and the resistor voltage $V_{R2}$ to the inductor current $i_L$ are the resistance values of the detection resistor R1 and the detection resistor R2.

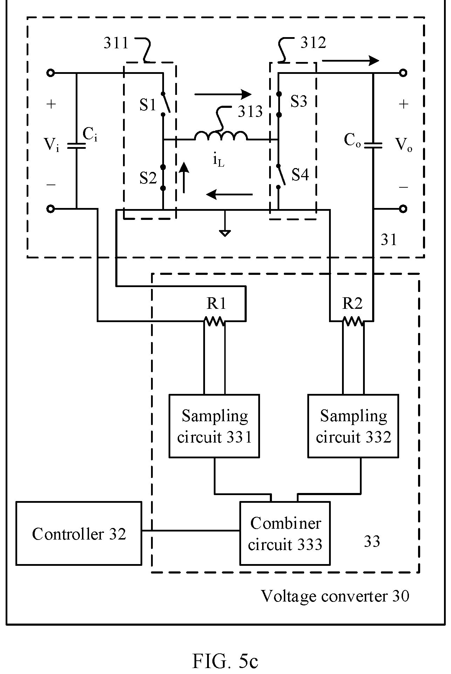

Inductor freewheeling phase: As described above, refer to FIG. 5c. In the inductor freewheeling phase of the buck conversion, the switching transistor S1 is open, the switching transistor S2 is conducted, the switching transistor S3 is kept conducted, and the switching transistor S4 is kept open. A current is output from an end that is of the inductor 313 and that is near the switching transistor S3, and is output through the high-potential output end of the buck-boost circuit 31 after being transmitted through the switching transistor S3. A returning current is input from the low-potential output end of the buck-boost circuit 31, and the current sequentially flows through the detection resistor R2 and the switching transistor S2 to return to an end that is of the inductor 313 and that is near the switching transistor S1.

In this phase, the inductor 313 is connected to the detection resistor R2 in series. Therefore, a current $i_{R2}$ flowing through the detection resistor R2 is equal to an inductor current $i_L$. In the inductor freewheeling phase, the inductor current $i_L$ gradually decreases. Therefore, as shown in FIG. 5a, in the time period t2, the current $i_{R2}$ flowing through the detection resistor R2 also gradually decreases. Because no current passes through the detection resistor R1 in the inductor freewheeling phase of the buck conversion, as shown in FIG. 5a, a current $i_{R1}$ of the detection resistor R1 in the time period t2 is zero.

Because the current $i_{R2}$ flowing through the detection resistor R2 is equal to the inductor current $i_L$, and the current $i_{R1}$ of the detection resistor R1 is zero, a resistor voltage $V_{R2}$ is greater than a resistor voltage $V_{R1}$, that is, a maximum voltage in the resistor voltage $V_{R1}$ and the resistor voltage $V_{R2}$ is the resistor voltage $V_{R2}$, and a ratio of the resistor voltage $V_{R2}$ to the inductor current $i_L$ is the resistance value of the detection resistor R2.

Therefore, it can be learned that, in the inductor charging phase and the inductor freewheeling phase of the buck conversion, the maximum voltage in the resistor voltage $V_{R1}$ and the resistor voltage $V_{R2}$ always keeps an equiproportional relationship with the inductor current $i_L$, and the ratio is the resistance value of the detection resistor R2.


Boost conversion

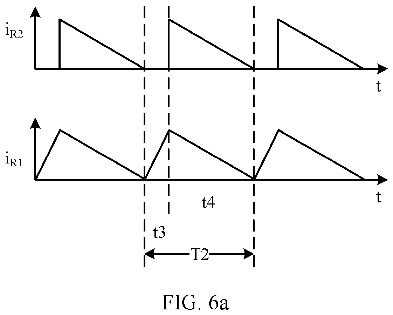

For example, FIG. 6a is a schematic diagram of current changes in the detection resistor R1 and the detection resistor R2 in a boost conversion process. A boost conversion cycle is T2, that is, the buck-boost circuit 31 can complete boost conversion once every T2 time. In FIG. 6a, each T2 includes two time periods t3 and t4, t3 represents an inductor charging phase in the boost conversion, and t4 represents an inductor freewheeling phase in the boost conversion. $i_{R2}$ represents a current flowing through the detection resistor R2, and $i_{R1}$ represents a current flowing through the detection resistor R1.

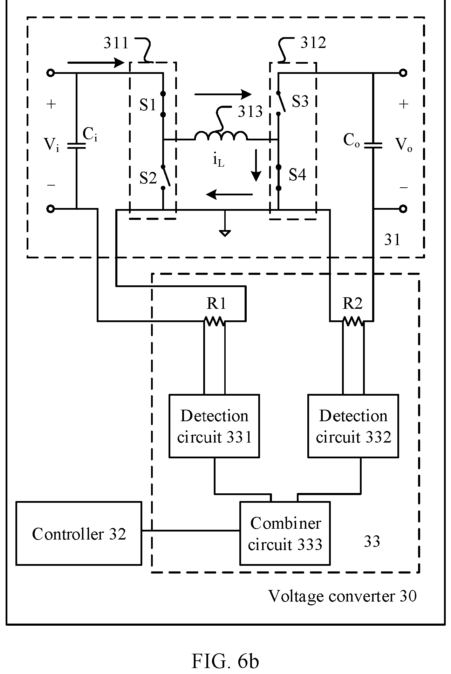

Inductor charging phase: As described above, refer to FIG. 6b. In the inductor charging phase of the boost conversion, the switching transistor S1 and the switching transistor S4 are conducted, and the switching transistor S2 and the switching transistor S3 are open. A current is input from the high-potential input end of the buck-boost circuit 31, and is output from the low-potential input end of the buck-boost circuit 11 after sequentially flowing through the switching transistor S1, the inductor 113, the switching transistor S4, and the detection resistor R1.

In this phase, the inductor 313 is connected to the detection resistor R1 in series. Therefore, a current $i_{R1}$ flowing through the detection resistor R1 is equal to an inductor current $i_L$. In the inductor charging phase of the boost conversion, the inductor current $i_L$ gradually increases. Therefore, as shown in FIG. 6a, in the time period t3, the current $i_{R1}$ flowing through the detection resistor R1 also gradually increases. Because no current passes through the detection resistor R2 in the inductor charging phase of the boost conversion, as shown in FIG. 6a, a current $i_{R2}$ of the detection resistor R2 in the time period t3 is zero.

Because the current $i_{R1}$ flowing through the detection resistor R1 is equal to the inductor current $i_L$, and the current $i_{R2}$ of the detection resistor R2 is zero, a resistor voltage $V_{R1}$ is greater than a resistor voltage $V_{R2}$, that is, a maximum voltage in the resistor voltage $V_{R1}$ and the resistor voltage $V_{R2}$ is the resistor voltage $V_{R1}$, and a ratio of the resistor voltage $V_{R1}$ to the inductor current $i_L$ is the resistance value of the detection resistor R1.

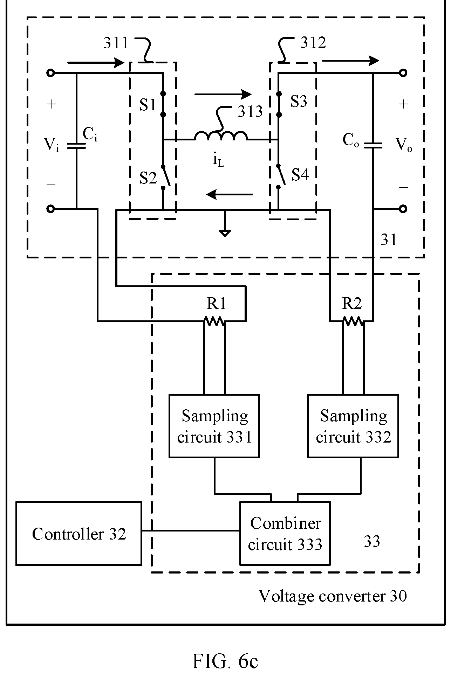

Inductor freewheeling phase: As described above, refer to FIG. 6c. In the inductor freewheeling phase of the boost conversion, the switching transistor S3 is conducted, the switching transistor S4 is open, the switching transistor S1 is kept conducted, and the switching transistor S2 is kept open. A current is input from the high-potential input end of the buck-boost circuit 31, sequentially flows through the switching transistor S1, the inductor 313, and the switching transistor S3, and is output from the high-potential output end of the buck-boost circuit 31 through the switching transistor S3. A returning current is input from the low-potential output end of the buck-boost circuit 31, sequentially flows through the detection resistor R2 and the detection resistor R1, and is output through the low-potential input end of the buck-boost circuit 31.

In this phase, the inductor 313, the detection resistor R2, and the detection resistor R1 are sequentially connected in series. Therefore, a current $i_{R1}$ flowing through the detection resistor R1 and a current $i_{R2}$ flowing through the detection resistor R2 are equal to an inductor current $i_L$. In the inductor freewheeling phase of the boost conversion, the inductor current $i_L$ gradually decreases. Therefore, as shown in FIG. 6a, in the time period t4, the current $i_{R1}$ flowing through the detection resistor R1 and the current $i_{R2}$ flowing through the detection resistor R2 also gradually decrease.

Because the current $i_{R1}$ flowing through the detection resistor R1 and the current $i_{R2}$ flowing through the detection resistor R2 are equal to the inductor current $i_L$, and the resistance value of the detection resistor R1 is equal to the resistance value of the detection resistor R2, a resistor voltage $V_{R1}$ is equal to a resistor voltage $V_{R2}$ in the inductor charging phase of the buck conversion, a maximum voltage in the resistor voltage $V_{R1}$ and the resistor voltage $V_{R2}$ is the resistor voltage $V_{R1}$ and the resistor voltage $V_{R2}$, and ratios of the resistor voltage $V_{R1}$ and the resistor voltage $V_{R2}$ to the inductor current $i_L$ are the resistance values of the detection resistor R1 and the detection resistor R2.

Therefore, it can be learned that, in the inductor charging phase and the inductor freewheeling phase of the boost conversion, the maximum voltage in the resistor voltage $V_{R1}$ and the resistor voltage $V_{R2}$ always keeps an equiproportional relationship with the inductor current $i_L$, and a correlation coefficient is the resistance value of the detection resistor R1.

In conclusion, whether in the buck conversion process or in the boost conversion process, the maximum voltage in the resistor voltage $V_{R1}$ and the resistor voltage $V_{R2}$ always keeps an equiproportional relationship with the inductor current $i_L$, and correlation coefficients are the resistance values of the detection resistor R1 and the detection resistor R2.

Therefore, the detection circuit 33 may further output a current detection signal $V_a$ based on the maximum voltage in the resistor voltage $V_{R1}$ and the resistor voltage $V_{R2}$, so that the current detection signal $V_a$ can indicate an inductor current $i_L$ passing through the detection resistor R1 and/or the detection resistor R2.

In this embodiment of this application, because the resistor voltage of the detection resistor R1 and/or the resistor voltage of the detection resistor R2 may change in real time with the inductor current $i_L$, a detection latency of the detection circuit 33 is relatively short. In addition, costs of the detection resistor R1 and the detection resistor R2 are lower than costs of a current sensor. Therefore, this embodiment of this application further helps reduce costs of the voltage converter 30.

As described above, the detection circuit 33 may output the current detection signal $V_a$ based on the maximum voltage in the resistor voltage $V_{R1}$ and the resistor voltage $V_{R2}$. For example, the current detection signal $V_a$ may be a voltage signal. A one-to-one correspondence exists between a voltage value of the current detection signal $V_a$ and the maximum voltage in the resistor voltage $V_{R1}$ and the resistor voltage $V_{R2}$. Because a fixed equiproportional relationship exists between the maximum voltage in the resistor voltage $V_{R1}$ and the resistor voltage $V_{R2}$ and the inductor current $i_L$, it may also be considered that a one-to-one correspondence exists between the voltage value of the current detection signal $V_a$ and the value of the inductor current $i_L$. Further, the voltage value of the current detection signal $V_a$ may indicate the value of the inductor current $i_L$.

For a receive end of the current detection signal $V_a$ (for example, the controller 32), the one-to-one correspondence between the voltage value of the current detection signal $V_a$ and the inductor current $i_L$ may be known or can be known, so that the receive end of the current detection signal $V_a$ can determine the value of the inductor current $i_L$ based on the voltage value of the received voltage detection signal $V_a$ and the correlation between the voltage value of the current detection signal $V_a$ and the inductor current $i_L$.

For example, the following relationship is met between the inductor current $i_L$ and the maximum voltage $V_{max}$ in the resistor voltage $V_{R1}$ and the resistor voltage $V_{R2}$:

$$V_{max} = i_L * R \text{ (formula 1),}$$

where

R represents the resistance value of the detection resistor R1 or the detection resistor R2.

The one-to-one correspondence between the current detection signal $V_a$ and the maximum voltage $V_{max}$ meets the following formula:

$$V_a = aV_{max} + b \text{ (formula 2),}$$

where

a and b are any constants.

It can be learned from both the formula 1 and the formula 2 that the one-to-one correspondence between the current detection signal $V_a$ and the inductor current $i_L$ meets the following formula:

$$V_a = ai_L*R + b \text{ (formula 3)}$$

For the receive end (for example, the controller 32) of the current detection signal $V_a$, the one-to-one correspondence shown in the formula 3 may be known, and values of a, R, and b may also be known. After receiving the current detection signal $V_a$, the receive end may obtain the value of the inductor current $i_L$ based on the voltage value of the current detection signal $V_a$ and the one-to-one correspondence shown in the formula 3.

For ease of understanding, next, this embodiment of this application provides descriptions by using an example in which the one-to-one correspondence between the voltage value of the current detection signal $V_a$ and the maximum voltage in the resistor voltage $V_{R1}$ and the resistor voltage $V_{R2}$ is a positive correlation shown in the formula 3, where a is greater than 0. An application scenario in another correlation may be obtained through adaptive adjustment based on subsequent descriptions in this embodiment of this application, and should also be included in this embodiment of this application.

It may be understood that the foregoing examples are all described by using an example in which only one inductor 313 exists in the buck-boost circuit 31. When a plurality of inductors 313 exist in the buck-boost circuit 31 (as shown in FIG. 4), a value that is of an inductor current $i_L$ and that is indicated by a current detection signal $V_a$ needs to be a sum of inductor currents of one or more inductors 313 in a charging/discharging process in the buck-boost circuit 31.

Next, the detection circuit 33 is further described by using the following examples in this embodiment of this application.

FIG. 3 is a schematic diagram of an example structure of a detection circuit according to an embodiment of this application. As shown in FIG. 3, the detection circuit 33 further includes a sampling circuit 331, a sampling circuit 332, and a combiner circuit 333. The sampling circuit 331 is separately connected to the two ends of the detection resistor R1 and the combiner circuit 333, and the sampling circuit 332 is separately connected to the two ends of the detection resistor R2 and the combiner circuit 333.

The sampling circuit 331 may perform sampling on the resistor voltage $V_{R1}$ of the detection resistor R1. Specifically, the sampling circuit 331 may output a sampled signal $V_{b1}$ to the combiner circuit 333 based on the resistor voltage $V_{R1}$ of the detection resistor R1. For example, the sampled signal $V_{b1}$ may be a voltage signal, and a voltage value of the sampled signal $V_{b1}$ may be in a positive correlation with a value of the resistor voltage $V_{R1}$. That is, a voltage of the sampled signal $V_{b1}$ may increase as the resistor voltage $V_{R1}$ increases, and decrease as the resistor voltage $V_{R1}$ decreases.

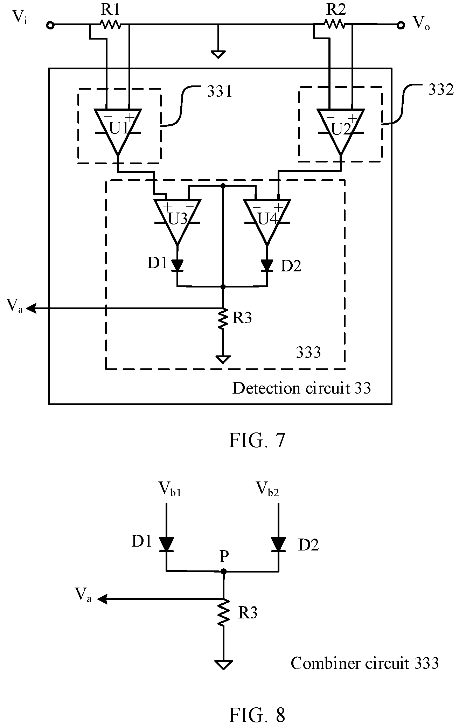

For example, as shown in FIG. 7, the sampling circuit 331 may include an operational amplifier circuit U1. One input end of the operational amplifier circuit U1 is connected to one end of the detection resistor R1, the other input end of the operational amplifier circuit U1 is connected to the other end of the detection resistor R1, and an output end of the operational amplifier circuit U1 is connected to the combiner circuit 333. The operational amplifier circuit U1 may perform differential sampling and amplification on the resistor voltage $V_{R1}$ of the detection resistor R1, to output the sampled signal $V_{b1}$ from the output end of the operational amplifier circuit U1.

For a specific implementation structure of the operational amplifier circuit U1, refer to those of various common operational amplifier circuits. This is not limited in this embodiment of this application.

The sampling circuit 332 may perform sampling on the resistor voltage $V_{R2}$ of the detection resistor R2. Specifically, the sampling circuit 332 may output a sampled signal $V_{b2}$ to the combiner circuit 333 based on the resistor voltage $V_{R2}$ of the detection resistor R2. For example, the sampled signal $V_{b2}$ may be a voltage signal, and a voltage value of the sampled signal $V_{b2}$ may be in a positive correlation with a value of the resistor voltage $V_{R2}$. A voltage of the sampled signal $V_{b2}$ may increase as the resistor voltage $V_{R2}$ increases, and decrease as the resistor voltage $V_{R2}$ decreases.

For example, as shown in FIG. 7, the sampling circuit 332 may include an operational amplifier circuit U2. One input end of the operational amplifier circuit U2 is connected to the other end of the detection resistor R2, the other input end of the operational amplifier circuit U2 is connected to one end of the detection resistor R2, and an output end of the operational amplifier circuit U2 is connected to the combiner circuit 333. The operational amplifier circuit U2 may perform differential sampling and amplification on the resistor voltage $V_{R2}$ of the detection resistor R2, to output the sampled signal $V_{b2}$ from the output end of the operational amplifier circuit U2.

For a specific implementation structure of the operational amplifier circuit U2, refer to those of various common operational amplifier circuits. This is not limited in this embodiment of this application.

It should be noted that the positive correlation between the sampled signal $V_{b1}$ and the resistor voltage

$V_{R1}$ and the correlation between the sampled signal $V_{b2}$ and the resistor voltage $V_{R2}$ may be a same positive correlation, to ensure that sampling results of the sampling circuit 331 and the sampling circuit 332 do not cause a change in a relative value relationship between the resistor voltage $V_{R1}$ and the resistor voltage $V_{R2}$. That is, the operational amplifier circuit U1 and the operational amplifier circuit U2 may have a same circuit structure.

For example, the voltage of the sampled signal Vb1 is equal to the resistor voltage $V_{R1}$, and the voltage of the sampled signal Vb2 is equal to the resistor voltage $V_{R2}$. For another example, the voltage of the sampled signal $V_{b1}$ is equal to $cV_{R1}+d$, and the voltage of the sampled signal $V_{b2}$ is equal to $cVR2+d$, where c is a constant greater than 0, and d is any constant.

For example, a non-inverting input end (+) of the operational amplifier circuit U1 may be connected to a high-potential end of the detection resistor R1, and an inverting input end (-) of the operational amplifier circuit U1 may be connected to a low-potential end of the detection resistor R1. A non-inverting input end (+) of the operational amplifier circuit U2 may be connected to a high-potential end of the detection resistor R2, and an inverting input end (-) of the operational amplifier circuit U1 may be connected to a low-potential end of the detection resistor R2.

For example, in FIG. 3, when the detection resistor R1 is connected to the low-potential input end of the buck-boost circuit 11, and the detection resistor R2 is connected to the low-potential output end of the buck-boost circuit 11, a current always flows from a side that is of the detection resistor R1 and that is near the low-potential output end of the buck-boost circuit 11 and/or a side that is of the detection resistor R2 and that is near the low-potential output end of the buck-boost circuit 11 to a side near the low-potential input end of the buck-boost circuit 11.

That is, one end that is of the detection resistor R1 and that is connected to the low-potential input end of the buck-boost circuit 11 is the low-potential end, and the other end that is of the detection resistor R1 and that is connected to the detection resistor R2 is the high-potential end. One end that is of the detection resistor R2 and that is connected to the low-potential output end of the buck-boost circuit 11 is the high-potential end, and the other end that is of the detection resistor R2 and that is connected to the detection resistor R1 is the low-potential end.

In view of this, as shown in FIG. 7, the inverting input end of the operational amplifier circuit U1 may be connected to an end that is of the detection resistor R1 and that is near the low-potential input end of the buck-boost circuit 11, and the non-inverting input end of the operational amplifier circuit U1 may be connected to an end that is of the detection resistor R1 and that is near the detection resistor R2. The inverting input end of the operational amplifier circuit U2 may be connected to an end that is of the detection resistor R2 and that is near the detection resistor R1, and the non-inverting input end of the operational amplifier circuit U2 may be connected to an end that is of the detection resistor R2 and that is near the low-potential output end of the buck-boost circuit 11.

The combiner circuit 333 may receive the sampled signal $V_{b1}$ and the sampled signal $V_{b2}$ that are provided by the detection circuit 331, and may further output the current detection signal $V_a$ based on a maximum voltage in the sampled signal $V_{b1}$ and the sampled signal $V_{b2}$. As described above, the positive correlation between the sampled signal $V_{b1}$ and the resistor voltage $V_{R1}$ and the correlation between the sampled signal $V_{b2}$ and the resistor voltage $V_{R2}$ may be a same positive correlation. Therefore, the maximum voltage in the sampled signal $V_{b1}$ and the sampled signal $V_{b2}$ also meet the positive correlation with the maximum voltage in the resistor voltage $V_{R1}$ and the resistor voltage $V_{R2}$. The combiner circuit 332 may output the current detection signal $V_a$ based on the maximum voltage in the sampled signal $V_{b1}$ and the sampled signal $V_{b2}$, so that the current detection signal $V_a$ can indicate the value of the inductor current $i_L$ passing through the detection resistor R1 and/or the detection resistor R2.

For example, as shown in FIG. 8, the combiner circuit 333 mainly includes a diode D1 and a diode D2. An anode of the diode D1 is connected to the sampling circuit 331, and can receive the sampled signal $V_{b1}$ provided by the sampling circuit 331. An anode of the diode D2 is connected to the sampling circuit 332, and can receive the sampled signal $V_{b2}$ provided by the sampling circuit 332. A cathode of the diode D1 is connected to a cathode of the diode D2 through a connection point P, and a voltage of the connection point P may be used as the current detection signal $V_a$.

Specifically, because the cathode of the diode D1 is connected to the cathode of the diode D2, a diode with a larger anode voltage may cause a diode with a lower anode voltage to be cut off. For example, if an anode voltage of the diode D1 is greater than an anode voltage of the diode D2, the diode D2 is cut off. Likewise, if an anode voltage of the diode D2 is greater than an anode voltage of the diode D1, the diode D1 is cut off.

In this embodiment of this application, the anode voltage of the diode D1 is the voltage of the sampled signal $V_{b1}$, and the anode voltage of the diode D2 is the voltage of the sampled signal $V_{b2}$. Therefore, when the voltage of the sampled signal $V_{b1}$ is greater than the voltage of the sampled signal $V_{b2}$, the diode D1 is conducted, and the voltage of the connection point P is the voltage of the sampled signal $V_{b1}$. When the voltage of the sampled signal $V_{b2}$ is greater than the voltage of the sampled signal $V_{b1}$, the diode D2 is conducted, and the voltage of the connection point P is the voltage of the sampled signal $V_{b2}$. When the voltage of the sampled signal $V_{b1}$ is equal to the voltage of the sampled signal $V_{b2}$, the diode D1 and the diode D2 can be both conducted, and the voltage of the connection point P is the voltage of the sampled signal $V_{b1}$ or the voltage of the sampled signal $V_{b2}$.

It can be learned that when the combiner circuit 333 shown in FIG. 8 is used, the voltage of the connection point P is the maximum voltage in the voltage of the sampled signal $V_{b1}$ and the voltage of the sampled signal $V_{b2}$. Therefore, the voltage of the connection point P can be used as the current detection signal $V_a$.

In specific implementation, because the diode has a specific conduction voltage drop, the voltage of the connection point P may be slightly lower than the maximum voltage in the voltage of the sampled signal $V_{b1}$ and the voltage of the sampled signal $V_{b2}$. This does not help improve current detection accuracy. In view of this, in a possible implementation, as shown in FIG. 8, the combiner circuit 333 may further include an operational amplifier circuit U3 and an operational amplifier circuit U4.

One input end of the operational amplifier circuit U3 is connected to the sampling circuit 331, and can receive the sampled signal $V_{b1}$. The other input end of the operational amplifier circuit U3 is connected to the cathode of the diode D1, and an output end of the operational amplifier circuit U3 is connected to the anode of the diode D1.

One input end of the operational amplifier circuit U4 is connected to the sampling circuit 332, and can receive the sampled signal $V_{b2}$. The other input end of the operational amplifier circuit U4 is connected to the cathode of the diode D2, and an output end of the operational amplifier circuit U4 is connected to the anode of the diode D2.

In the operational amplifier circuit U3, an input end connected to the operational amplifier circuit U1 may be a non-inverting input end, and an input end connected to the diode D1 may be an inverting input end. In the operational amplifier circuit U4, an input end connected to the operational amplifier circuit U2 may be a non-inverting input end, and an input end connected to the diode D2 may be an inverting input end. This connection manner helps keep a voltage output by the diode D1 and/or a voltage output by the diode D2 non-inverting with the voltage of the sampled signal $V_{b1}$ and/or the voltage of the sampled signal $V_{b1}$.

The operational amplifier circuit U3 is used as an example. Voltages of the two input ends of the operational amplifier circuit U3 are respectively the voltage of the sampled signal $V_{b1}$ and a cathode voltage of the diode D1. According to a "virtual short circuit" characteristic of the operational amplifier circuit, that is, the voltages of the two input ends of the operational amplifier circuit U3 are equal, the voltage of the sampled signal $V_{b1}$ can be kept equal to the cathode voltage of the diode D1, thereby achieving a voltage following effect. The operational amplifier circuit U4 can be likewise understood, and is not described in detail.

For specific implementations of the operational amplifier circuit U3 and the operational amplifier circuit U4, refer to those of common operational amplifier circuits. This is not limited in this embodiment of this application.

In a possible implementation, as shown in FIG. 7, the combiner circuit 333 may further include a ground resistor R3. One end of the ground resistor R3 is connected to the connection point P, and the other end of the ground resistor R3 is grounded. The ground resistor R3 is added, so that the diode D 1 and the diode D2 can be prevented from being short-circuited with the ground, and further, the voltage of the connection point P can be prevented from being locked at 0 V.

In conclusion, in this embodiment of this application, the detection circuit 33 may generate the current detection signal $V_a$ based on the detection resistor R1 and the detection resistor R2, to detect the inductor current $i_L$. Compared with a current detection solution based on a current sensor, in this embodiment of this application, sampling is performed by using the detection resistors, so that a sampling result is more accurate and the sampling is faster. It should be noted that the detection circuit 33 in this embodiment of this application may automatically adapt to different voltage conversion processes of the buck-boost circuit 31 without extra control. This further helps save a control resource.

Based on a same technical concept, an embodiment of this application further provides an electronic device, mainly including the voltage converter provided in any one of the foregoing embodiments of this application. For example, the electronic device may be an electric vehicle, a photovoltaic station, a communications power supply device, or the like.

## Claims

1. A voltage conversion circuit, comprising a detection circuit (33) having a first detection resistor (R1) and a second detection resistor (R2), and a buck-boost circuit (31) of an H-bridge structure, wherein

   the buck-boost circuit (31) comprises a first bridge arm (311), a second bridge arm (312), and an inductor (313),
   the inductor (313) is located between the first bridge arm (311) and the second bridge arm (312),
   a first end of the first bridge arm (311) is connected to a low-potential input end of the buck-boost circuit (31) through the first detection resistor (R1), and a second end of the first bridge arm (311) is connected to a high-potential input end of the buck-boost circuit (31),
   a first end of the second bridge arm (312) is connected to a low-potential output end of the buck-boost circuit (31) through the second detection resistor (R2), and a second end of the second bridge arm (312) is connected to a high-potential output end of the buck-boost circuit (31)

the first end of the first bridge arm (311) and the first end of the second bridge arm (312) are directly connected to one another such that the first detection resistor (R1) and the second detection resistor (R2) are in series between the low-potential input end of the buck-boost circuit (31) and the low-potential output end of the buck-boost circuit (31); the detection circuit (33) is configured to:

separately performing voltage sampling on a first resistor voltage ($V_{R1}$) of the first detection resistor (R1) and a second resistor voltage ($V_{R2}$) of the second detection resistor (R2); and

output a current detection signal (Va) based on a maximum voltage in the first resistor voltage ($V_{R1}$) and the second resistor voltage ($V_{R2}$), wherein the maximum voltage in the first resistor voltage ($V_{R1}$) and the second resistor voltage ($V_{R2}$) is a voltage of a detection resistor through which an inductor current of the inductor (313) passes, and the current detection signal (Va) is used to indicate a value of the inductor current;

wherein the detection circuit (33) further comprises a first sampling circuit (331), a second sampling circuit (332), and a combiner circuit (333), wherein:

the first sampling circuit (331) is separately connected to two ends of the first detection resistor (R1) and the combiner circuit (333), and the second sampling circuit (332) is separately connected to two ends of the second detection resistor (R2) and the combiner circuit (333);

the first sampling circuit (331) is configured to output a first sampled signal (Vb1) to the combiner circuit (333) based on the first resistor voltage (VR1) of the first detection resistor (R1), wherein a voltage of the first sampled signal (Vb1) meets a positive correlation with the first resistor voltage (VR1);

the second sampling circuit (332) is configured to output a second sampled signal (Vb2) to the combiner circuit (333) based on the second resistor voltage (VR2) of the second detection resistor (R2), wherein a voltage of the second sampled signal (Vb2) meets a positive correlation with the second resistor voltage (VR2); and

the combiner circuit (333) is configured to output the current detection signal (Va) based on a maximum voltage in the first sampled signal (Vb1) and the second sampled signal (Vb2);

the voltage conversion circuit is **characterised in that**:

the combiner circuit (333) comprises a first diode (D1) and a second diode (D2), an anode of the first diode (D1) is connected to the first sampling circuit (331), an anode of the second diode (D2) is connected to the second sampling circuit (332), a cathode of the first diode (D1) is connected to a cathode of the second diode (D2) through a first connection point (P), and the first connection point (P) is configured to output the current detection signal (Va);

the combiner circuit (333) further comprises a third operational amplifier circuit (U3) and a fourth operational amplifier circuit (U4);

one input end of the fourth operational amplifier circuit (U4) is connected to the second sampling circuit (332), and is configured to receive the second sampled signal (Vb2);

the other input end of the fourth operational amplifier circuit (U4) is connected to the cathode of the second diode (D2), and an output end of the fourth operational amplifier circuit (U4) is connected to the anode of the second diode (D2);

one input end of the third operational amplifier circuit (U3) is connected to the first sampling circuit (331), and is configured to receive the first sampled signal (Vb1); and the other input end of the third operational amplifier circuit (U3) is connected to the cathode of the first diode (D1), and an output end of the third operational amplifier circuit (U3) is connected to the anode of the first diode (D1).

2.  The voltage conversion circuit according to claim 1, wherein the buck-boost circuit (31) further comprises an input capacitor ($C_i$), one end of the input capacitor ($C_i$) is connected to the high-potential input end of the buck-boost circuit (31), the other end of the input capacitor ($C_i$) is connected to the low-potential input end of the buck-boost circuit (31), and the first detection resistor (R1) is located between the input capacitor ($C_i$) and the first bridge arm (311).

3. The voltage conversion circuit according to any one of claims 1 or 2, wherein the buck-boost circuit (31) further comprises an output capacitor ($C_o$), one end of the output capacitor ($C_o$) is connected to the high-potential output end of the buck-boost circuit (31), the other end of the output capacitor ($C_o$) is connected to the low-potential output end of the buck-boost circuit (31), and the second detection resistor (R2) is located between the output capacitor ($C_o$) and the second bridge arm (312).

4. The voltage conversion circuit according to claim 1, wherein the first sampling circuit (331) comprises a first operational amplifier circuit (U1), one input end of the first operational amplifier circuit (U1) is connected to one end of the first detection resistor (R1), the other input end of the first operational amplifier circuit (U1) is connected to the other end of the first detection resistor (R1), and an output end of the first operational amplifier circuit (U1) is configured to output the first sampled signal ($V_{b1}$).

5. The voltage conversion circuit according to any of claims 1 to 4, wherein the second sampling circuit (332) comprises a second operational amplifier circuit (U2), one input end of the second operational amplifier circuit (U2) is connected to one end of the second detection resistor (R2), the other input end of the second operational amplifier circuit (U2) is connected to the other end of the second detection resistor (R2), and an output end of the second operational amplifier circuit (U2) is configured to output the second sampled signal ($V_{b2}$).

6. The voltage conversion circuit according to any of claims 1 to 5, wherein the combiner circuit (333) further comprises a ground resistor (R3), one end of the ground resistor (R3) is connected to the first connection point (P), and the other end of the ground resistor (R3) is grounded.

7. The voltage conversion circuit according to any one of claims 1 to 6, wherein the buck-boost circuit (31) comprises a plurality of first bridge arms (311), a plurality of second bridge arms (312), and a plurality of inductors (313); and the plurality of first bridge arms (311) are connected in parallel, the plurality of second bridge arms (312) are connected in parallel, the plurality of inductors (313) are connected to the plurality of first bridge arms (311) and the plurality of second bridge arms (312) in a one-to-one correspondence, one end of each inductor (313) is connected to a first bridge arm (311) corresponding to each inductor (313), and the other end of each inductor (313) is connected to a second bridge arm (312) corresponding to each inductor (313).

8. A voltage converter (30), comprising a controller and the voltage conversion circuit according to any one of claims 1 to 7, wherein
the controller (32) is configured to control the voltage conversion circuit to perform voltage conversion.

9. An electronic device, comprising the voltage converter (30) according to claim 8.

**Patentansprüche**

1. Spannungswandlungsschaltung, die eine Detektionsschaltung (33) mit einem ersten Detektionswiderstand (R1) und einem zweiten Detektionswiderstand (R2) und eine Tief-Hochsetzsteller-Schaltung (31) einer H-Brückenstruktur umfasst, wobei die Tief-Hochsetzsteller-Schaltung (31) einen ersten Brückenzweig (311), einen zweiten Brückenzweig (312) und eine Spule (313) umfasst,

die Spule (313) sich zwischen dem ersten Brückenzweig (311) und dem zweiten Brückenzweig (312) befindet,
ein erstes Ende des ersten Brückenzweigs (311) über den ersten Detektionswiderstand (R1) an ein Niederspannungseingangsende der Tief-Hochsetzsteller-Schaltung (31) angeschlossen ist und ein zweites Ende des ersten Brückenzweigs (311) an ein Hochspannungseingangsende der Tief-Hochsetzsteller-Schaltung (31) angeschlossen ist,
ein erstes Ende des zweiten Brückenzweigs (312) über den zweiten Detektionswiderstand (R2) an ein Niederspannungsausgangsende der Tief-Hochsetzsteller-Schaltung (31) angeschlossen ist und ein zweites Ende des zweiten Brückenzweigs (312) an ein Hochspannungsausgangsende der Tief-Hochsetzsteller-Schaltung (31) angeschlossen ist,
das erste Ende des ersten Brückenzweigs (311) und das erste Ende des zweiten Brückenzweigs (312) direkt aneinander angeschlossen sind, sodass der erste Detektionswiderstand (R1) und der zweite Detektionswiderstand (R2) zwischen dem Niederspannungseingangsende der Tief-Hochsetzsteller-Schaltung (31) und dem Niederspannungsausgangsende der Tief-Hochsetzsteller-Schaltung (31) in Reihe geschaltet sind; die Detektionsschaltung (33) zu Folgendem konfiguriert ist:

separates Durchführen einer Spannungsabtastung an einer ersten Widerstandsspannung ($V_{R1}$) des ersten Detektionswiderstands (R1) und einer zweiten Widerstandsspannung ($V_{R2}$) des zweiten Detektionswiderstands (R2); und

Ausgeben eines Stromdetektionssignals (Va) basierend auf einer Höchstspannung in der ersten Widerstandsspannung ($V_{R1}$) und der zweiten Widerstandsspannung ($V_{R2}$), wobei die Höchstspannung in der ersten Widerstandsspannung ($V_{R1}$) und der zweiten Widerstandsspannung ($V_{R2}$) eine Spannung eines Detektionswiderstands ist, durch den ein Spulenstrom der Spule (313) hindurchfließt, und das Stromdetektionssignal (Va) genutzt wird, um einen Wert des Spulenstroms anzuzeigen;

wobei die Detektionsschaltung (33) ferner eine erste Abtastschaltung (331), eine zweite Abtastschaltung (332) und eine Kombiniererschaltung (333) umfasst, wobei:

die erste Abtastschaltung (331) an zwei Enden des ersten Detektionswiderstands (R1) und die Kombiniererschaltung (333) separat angeschlossen ist und die zweite Abtastschaltung (332) an zwei Enden des zweiten Detektionswiderstands (R2) und die Kombiniererschaltung (333) separat angeschlossen ist;

die erste Abtastschaltung (331) dazu konfiguriert ist, ein erstes abgetastetes Signal (Vb1) basierend auf der ersten Widerstandsspannung (VR1) des ersten Detektionswiderstands (R1) an die Kombiniererschaltung (333) auszugeben, wobei eine Spannung des ersten abgetasteten Signals (Vb1) eine positive Korrelation mit der ersten Widerstandsspannung (VR1) erfüllt;

die zweite Abtastschaltung (332) dazu konfiguriert ist, ein zweites abgetastetes Signal (Vb2) basierend auf der zweiten Widerstandsspannung (VR2) des zweiten Detektionswiderstands (R2) an die Kombiniererschaltung (333) auszugeben, wobei eine Spannung des zweiten abgetasteten Signals (Vb2) eine positive Korrelation mit der zweiten Widerstandsspannung (VR2) erfüllt; und

die Kombiniererschaltung (333) dazu konfiguriert ist, das Stromdetektionssignal (Va) basierend auf einer Höchstspannung in dem ersten abgetasteten Signal (Vb1) und dem zweiten abgetasteten Signal (Vb2) auszugeben;

die Spannungswandlungsschaltung **dadurch gekennzeichnet ist, dass**:

die Kombiniererschaltung (333) eine erste Diode (D1) und eine zweite Diode (D2) umfasst, eine Anode der ersten Diode (D1) an die erste Abtastschaltung (331) angeschlossen ist, eine Anode der zweiten Diode (D2) an die zweite Abtastschaltung (332) angeschlossen ist, eine Kathode der ersten Diode (D1) über einen ersten Anschlusspunkt (P) an eine Kathode der zweiten Diode (D2) angeschlossen ist und der erste Anschlusspunkt (P) dazu konfiguriert ist, das Stromdetektionssignal (Va) auszugeben;

die Kombiniererschaltung (333) ferner eine dritte Operationsverstärkerschaltung (U3) und eine vierte Operationsverstärkerschaltung (U4) umfasst;

ein Eingangsende der vierten Operationsverstärkerschaltung (U4) an die zweite Abtastschaltung (332) angeschlossen ist und dazu konfiguriert ist, das zweite abgetastete Signal (Vb2) zu empfangen;

das andere Eingangsende der vierten Operationsverstärkerschaltung (U4) an die Kathode der zweiten Diode (D2) angeschlossen ist und ein Ausgangsende der vierten Operationsverstärkerschaltung (U4) an die Anode der zweiten Diode (D2) angeschlossen ist;

ein Eingangsende der dritten Operationsverstärkerschaltung (U3) an die erste Abtastschaltung (331) angeschlossen ist und dazu konfiguriert ist, das erste abgetastete Signal (Vb1) zu empfangen; und

das andere Eingangsende der dritten Operationsverstärkerschaltung (U3) an die Kathode der ersten Diode (D1) angeschlossen ist und ein Ausgangsende der dritten Operationsverstärkerschaltung (U3) an die Anode der ersten Diode (D1) angeschlossen ist.

2. Spannungswandlungsschaltung nach Anspruch 1, wobei die Tief-Hochsetzsteller-Schaltung (31) ferner einen Eingangskondensator ($C_i$) umfasst, ein Ende des Eingangskondensators ($C_i$) an das Hochspannungseingangsende der Tief-Hochsetzsteller-Schaltung (31) angeschlossen ist, das andere Ende des Eingangskondensators ($C_i$) an das Niederspannungseingangsende der Tief-Hochsetzsteller-Schaltung (31) angeschlossen ist und der erste Detektionswiderstand (R1) sich zwischen dem Eingangskondensator ($C_i$) und dem ersten Brückenzweig (311) befindet.

**3.** Spannungswandlungsschaltung nach Anspruch 1 oder 2, wobei die Tief-Hochsetzsteller-Schaltung (31) ferner einen Ausgangskondensator ($C_o$) umfasst, ein Ende des Ausgangskondensators ($C_o$) an das Hochspannungsausgangsende der Tief-Hochsetzsteller-Schaltung (31) angeschlossen ist, das andere Ende des Ausgangskondensators ($C_o$) an das Niederspannungsausgangsende der Tief-Hochsetzsteller-Schaltung (31) angeschlossen ist und der zweite Detektionswiderstand (R2) sich zwischen dem Ausgangskondensator ($C_o$) und dem zweiten Brückenzweig (312) befindet.

**4.** Spannungswandlungsschaltung nach Anspruch 1, wobei die erste Abtastschaltung (331) eine erste Operationsverstärkerschaltung (U1) umfasst, ein Eingangsende der ersten Operationsverstärkerschaltung (U1) an ein Ende des ersten Detektionswiderstands (R1) angeschlossen ist, das andere Eingangsende der ersten Operationsverstärkerschaltung (U1) an das andere Ende des ersten Detektionswiderstands (R1) angeschlossen ist und ein Ausgangsende der ersten Operationsverstärkerschaltung (U1) dazu konfiguriert ist, das erste abgetastete Signal (Vb1) auszugeben.

**5.** Spannungswandlungsschaltung nach einem der Ansprüche 1 bis 4, wobei die zweite Abtastschaltung (332) eine zweite Operationsverstärkerschaltung (U2) umfasst, ein Eingangsende der zweiten Operationsverstärkerschaltung (U2) an ein Ende des zweiten Detektionswiderstands (R2) angeschlossen ist, das andere Eingangsende der zweiten Operationsverstärkerschaltung (U2) an das andere Ende des zweiten Detektionswiderstands (R2) angeschlossen ist und ein Ausgangsende der zweiten Operationsverstärkerschaltung (U2) dazu konfiguriert ist, das zweite abgetastete Signal ($V_{b2}$) auszugeben.

**6.** Spannungswandlungsschaltung nach einem der Ansprüche 1 bis 5, wobei die Kombiniererschaltung (333) ferner einen Massewiderstand (R3) umfasst, ein Ende des Massewiderstands (R3) an den ersten Anschlusspunkt (P) angeschlossen ist und das andere Ende des Massewiderstands (R3) an Masse angeschlossen ist.

**7.** Spannungswandlungsschaltung nach einem der Ansprüche 1 bis 6, wobei die Tief-Hochsetzsteller-Schaltung (31) eine Vielzahl erster Brückenzweige (311), eine Vielzahl zweiter Brückenzweige (312) und eine Vielzahl von Spulen (313) umfasst; und die Vielzahl erster Brückenzweige (311) parallel geschaltet ist, die Vielzahl zweiter Brückenzweige (312) parallel geschaltet ist, die Vielzahl von Spulen (313) an die Vielzahl erster Brückenzweige (311) und die Vielzahl zweiter Brückenzweige (312) in einer Eins-zu-eins-Entsprechung angeschlossen ist, ein Ende jeder Spule (313) an einen ersten Brückenzweig (311), der jeder Spule (313) entspricht, angeschlossen ist und das andere Ende jeder Spule (313) an einen zweiten Brückenzweig (312), der jeder Spule (313) entspricht, angeschlossen ist.

**8.** Spannungswandler (30), der eine Steuerung und die Spannungswandlungsschaltung nach einem der Ansprüche 1 bis 7 umfasst, wobei

die Steuerung (32) dazu konfiguriert ist, die Spannungswandlungsschaltung zum Durchführen einer Spannungswandlung zu steuern.

**9.** Elektronische Vorrichtung, die den Spannungswandler (30) nach Anspruch 8 umfasst.

## Revendications

**1.** Circuit de conversion de tension, comprenant un circuit de détection (33) ayant une première résistance de détection (R1) et une seconde résistance de détection (R2), et un circuit abaisseur-élévateur (31) d'une structure de pont en H, dans lequel le circuit abaisseur-élévateur (31) comprend un premier bras de pont (311), un second bras de pont (312), et une bobine d'inductance (313),

la bobine d'inductance (313) est située entre le premier bras de pont (311) et le second bras de pont (312),
une première extrémité du premier bras de pont (311) est reliée à une extrémité d'entrée de faible potentiel du circuit abaisseur-élévateur (31) par l'intermédiaire de la première résistance de détection (R1), et une seconde extrémité du premier bras de pont (311) est reliée à une extrémité d'entrée de haut potentiel du circuit abaisseur-élévateur (31),
une première extrémité du second bras de pont (312) est reliée à une extrémité de sortie de faible potentiel du circuit abaisseur-élévateur (31) par l'intermédiaire de la seconde résistance de détection (R2), et une seconde extrémité du second bras de pont (312) est reliée à une extrémité de sortie de haut potentiel du circuit abaisseur-élévateur (31),
la première extrémité du premier bras de pont (311) et la première extrémité du second bras de pont (312) sont reliées directement l'une à l'autre de telle sorte que la première résistance de détection (R1) et la seconde résistance de détection (R2) sont en série entre l'extrémité d'entrée de faible potentiel du circuit abaisseur-élévateur (31) et l'extrémité de sortie de faible potentiel du circuit abaisseur-élévateur (31) ;
le circuit de détection (33) est configuré pour :

réaliser séparément un échantillonnage de tension sur une première tension de résistance ($V_{R1}$) de la première résistance de détection (R1) et une seconde tension de résistance ($V_{R2}$) de la seconde résistance de détection (R2) ; et

émettre un signal de détection de courant (Va) basé sur une tension maximale dans la première tension de résistance ($V_{R1}$) et la seconde tension de résistance ($V_{R2}$), dans lequel la tension maximale dans la première tension de résistance ($V_{R1}$) et la seconde tension de résistance ($V_{R2}$) est une tension d'une résistance de détection que traverse un courant de bobine d'inductance de la bobine d'inductance (313), et le signal de détection de courant (Va) est utilisé pour indiquer une valeur du courant de bobine d'inductance ;

dans lequel le circuit de détection (33) comprend en outre un premier circuit d'échantillonnage (331), un second circuit d'échantillonnage (332), et un circuit combineur (333), dans lequel :

le premier circuit d'échantillonnage (331) est relié séparément à deux extrémités de la première résistance de détection (R1) et du circuit combineur (333), et le second circuit d'échantillonnage (332) est relié séparément à deux extrémités de la seconde résistance de détection (R2) et du circuit combineur (333) ;

le premier circuit d'échantillonnage (331) est configuré pour émettre un premier signal échantillonné (Vb1) au circuit combineur (333) sur la base de la première tension de résistance (VR1) de la première résistance de détection (R1), dans lequel une tension du premier signal échantillonné (Vb1) répond à une corrélation positive avec la première tension de résistance (VR1) ;

le second circuit d'échantillonnage (332) est configuré pour émettre un second signal échantillonné (Vb2) au circuit combineur (333) sur la base de la seconde tension de résistance (VR2) de la seconde résistance de détection (R2), dans lequel une tension du second signal échantillonné (Vb2) répond à une corrélation positive avec la seconde tension de résistance (VR2) ; et

le circuit combineur (333) est configuré pour émettre le signal de détection de courant (Va) basé sur une tension maximale dans le premier signal échantillonné (Vb1) et le second signal échantillonné (Vb2) ;

le circuit de conversion de tension est **caractérisé en ce que** :

le circuit combineur (333) comprend une première diode (D1) et une seconde diode (D2), une anode de la première diode (D1) est reliée au premier circuit d'échantillonnage (331), une anode de la seconde diode (D2) est reliée au second circuit d'échantillonnage (332), une cathode de la première diode (D1) est reliée à une cathode de la seconde diode (D2) par l'intermédiaire d'un premier point de liaison (P), et le premier point de liaison (P) est configuré pour émettre le signal de détection de courant (Va) ;

le circuit combineur (333) comprend en outre un troisième circuit amplificateur opérationnel (U3) et un quatrième circuit amplificateur opérationnel (U4) ;

une extrémité d'entrée du quatrième circuit amplificateur opérationnel (U4) est reliée au second circuit d'échantillonnage (332), et est configurée pour recevoir le second signal échantillonné (Vb2) ;

l'autre extrémité d'entrée du quatrième circuit amplificateur opérationnel (U4) est reliée à la cathode de la seconde diode (D2), et une extrémité de sortie du quatrième circuit amplificateur opérationnel (U4) est reliée à l'anode de la seconde diode (D2) ;

une extrémité d'entrée du troisième circuit amplificateur opérationnel (U3) est reliée au premier circuit d'échantillonnage (331), et est configurée pour recevoir le premier signal échantillonné (Vb1) ; et

l'autre extrémité d'entrée du troisième circuit amplificateur opérationnel (U3) est reliée à la cathode de la première diode (D1), et une extrémité de sortie du troisième circuit amplificateur opérationnel (U3) est reliée à l'anode de la première diode (D1).

2. Circuit de conversion de tension selon la revendication 1, dans lequel le circuit abaisseur-élévateur (31) comprend en outre un condensateur d'entrée ($C_i$),

une extrémité du condensateur d'entrée (C$_i$) est reliée à l'extrémité d'entrée de haut potentiel du circuit abaisseur-élévateur (31), l'autre extrémité du condensateur d'entrée (C$_i$) est reliée à l'extrémité d'entrée de faible potentiel du circuit abaisseur-élévateur (31), et la première résistance de détection (R1) est située entre le condensateur d'entrée (C$_i$) et le premier bras de pont (311).

**3.** Circuit de conversion de tension selon l'une quelconque des revendications 1 ou 2, dans lequel le circuit abaisseur-élévateur (31) comprend en outre un condensateur de sortie (C$_o$), une extrémité du condensateur de sortie (C$_o$) est reliée à l'extrémité de sortie de haut potentiel du circuit abaisseur-élévateur (31), l'autre extrémité du condensateur de sortie (C$_o$) est reliée à l'extrémité de sortie de faible potentiel du circuit abaisseur-élévateur (31), et la seconde résistance de détection (R2) est située entre le condensateur de sortie (C$_o$) et le second bras de pont (312).

**4.** Circuit de conversion de tension selon la revendication 1, dans lequel le premier circuit d'échantillonnage (331) comprend un premier circuit amplificateur opérationnel (U1), une extrémité d'entrée du premier circuit amplificateur opérationnel (U1) est reliée à une extrémité de la première résistance de détection (R1), l'autre extrémité d'entrée du premier circuit amplificateur opérationnel (U1) est reliée à l'autre extrémité de la première résistance de détection (R1), et une extrémité de sortie du premier circuit amplificateur opérationnel (U1) est configurée pour émettre le premier signal échantillonné (V$_{b1}$).

**5.** Circuit de conversion de tension selon l'une quelconque des revendications 1 à 4, dans lequel le second circuit d'échantillonnage (332) comprend un second circuit amplificateur opérationnel (U2), une extrémité d'entrée du second circuit amplificateur opérationnel (U2) est reliée à une extrémité de la seconde résistance de détection (R2), l'autre extrémité d'entrée du second circuit amplificateur opérationnel (U2) est reliée à l'autre extrémité de la seconde résistance de détection (R2), et une extrémité de sortie du second circuit amplificateur opérationnel (U2) est configurée pour émettre le second signal échantillonné (V$_{b2}$).

**6.** Circuit de conversion de tension selon l'une quelconque des revendications 1 à 5, dans lequel le circuit combineur (333) comprend en outre une résistance de terre (R3), une extrémité de la résistance de terre (R3) est reliée au premier point de liaison (P), et l'autre extrémité de la résistance de terre (R3) est mise à la terre.

**7.** Circuit de conversion de tension selon l'une quelconque des revendications 1 à 6, dans lequel le circuit abaisseur-élévateur (31) comprend une pluralité de premiers bras de pont (311), une pluralité de seconds bras de pont (312), et une pluralité de bobines d'inductance (313) ; et la pluralité de premiers bras de pont (311) sont reliés en parallèle, la pluralité de seconds bras de pont (312) sont reliés en parallèle, la pluralité de bobines d'inductance (313) sont reliées à la pluralité de premiers bras de pont (311) et à la pluralité de seconds bras de pont (312) dans une correspondance biunivoque, une extrémité de chaque bobine d'inductance (313) est reliée à un premier bras de pont (311) correspondant à chaque bobine d'inductance (313) et l'autre extrémité de chaque bobine d'inductance (313) est reliée à un second bras de pont (312) correspondant à chaque bobine d'inductance (313).

**8.** Convertisseur de tension (30), comprenant un dispositif de commande et le circuit de conversion de tension selon l'une quelconque des revendications 1 à 7, dans lequel le dispositif de commande (32) est configuré pour commander le circuit de conversion de tension pour réaliser une conversion de tension.

**9.** Dispositif électronique, comprenant le convertisseur de tension (30) selon la revendication 8.

```
┌──────────────────────────────────────────────────────────┐
│                                                            │
│                                                            │
│        ┌────────────────────────────────────────┐         │
│  Vi →  │                                         │  Vo →   │
│        │   Buck-boost (Buck-Boost) circuit 11    │         │
│  ───→  │                                         │  ───→   │
│        └────────────────────────────────────────┘         │
│               │                      │                     │
│        ┌──────────────┐      ┌──────────────────┐          │
│        │              │      │ Detection circuit│          │
│        │ Controller 12│──────│        13        │          │
│        └──────────────┘      └──────────────────┘          │
│                                                            │
│                                    Voltage converter 10    │
└──────────────────────────────────────────────────────────┘
```

FIG. 1

Buck-boost (Buck-Boost) circuit 11

FIG. 2a

Buck-boost (Buck-Boost) circuit 11

FIG. 2b

Buck-boost (Buck-Boost) circuit 11

FIG. 2c

Buck-boost (Buck-Boost) circuit 11

FIG. 2d

Buck-boost (Buck-Boost) circuit 11

FIG. 2e

FIG. 3

Buck-boost circuit 31

FIG. 4

FIG. 5a

FIG. 5b

FIG. 5c

FIG. 6a

FIG. 6b

FIG. 6c

$V_i$  R1  R2  $V_o$

331

U1

332

U2

U3  U4

D1  D2

$V_a$  R3

333

Detection circuit 33

FIG. 7

$V_{b1}$  $V_{b2}$

D1  P  D2

$V_a$  R3

Combiner circuit 333

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 107561343 A
- JP 2005237052 A